(19)

**Europäisches Patentamt**
**European Patent Office**
**Office européen des brevets**

(11)  **EP 2 063 276 A1**

(12)  **EUROPEAN PATENT APPLICATION**
published in accordance with Art. 153(4) EPC

(43) Date of publication:
  **27.05.2009 Bulletin 2009/22**

(51) Int Cl.:
  *G01R 31/12* $^{(2006.01)}$

(21) Application number: **06797282.8**

(22) Date of filing: **01.09.2006**

(86) International application number:
  **PCT/JP2006/317340**

(87) International publication number:
  **WO 2008/026291 (06.03.2008 Gazette 2008/10)**

(84) Designated Contracting States:
  **AT BE BG CH CY CZ DE DK EE ES FI FR GB GR HU IE IS IT LI LT LU LV MC NL PL PT RO SE SI SK TR**
  Designated Extension States:
  **AL BA HR MK RS**

(71) Applicants:
  • **MITSUBISHI ELECTRIC CORPORATION**
   **Chiyoda-ku**
   **Tokyo 100-8310 (JP)**
  • **THE TOKYO ELECTRIC POWER COMPANY INCORPORATED**
   **Tokyo 100-8560 (JP)**

(72) Inventors:
  • **NISHIDA, Chieko**
   **Tokyo 100-8310 (JP)**

  • **KAMEI, Mitsuhito**
   **Tokyo 100-8310 (JP)**
  • **OKABE, Shigemitsu**
   **Tokyo 100-8560 (JP)**
  • **KANEKO, Shuhei**
   **Tokyo 100-8560 (JP)**
  • **YOSHIMURA, Manabu**
   **Tokyo 100-8310 (JP)**
  • **MUTO, Hirotaka**
   **Tokyo 100-8310 (JP)**

(74) Representative: **Sajda, Wolf E. et al**
  **Meissner, Bolte & Partner GbR**
  **Postfach 86 06 24**
  **81633 München (DE)**

(54)  **PARTIAL DISCHARGE DETECTION METHOD AND PARTIAL DISCHARGE DETECTION DEVICE**

(57)  In a method of determining partial discharge which detects an electromagnetic wave signal, which propagates in metal tank, at a plurality of outer circumferential positions of the insulating spacer with an electromagnetic wave detector; extracts a signal of a frequency band in which a TE11 mode propagates but a TE21 mode does not propagate by utilizing a cutoff frequency from the detected electromagnetic wave signal, with a TE11 envelope detector; and determines a partial discharge by detecting an intensity distribution of outer circumferential electromagnetic waves in the metal tank with an intensity detector from the intensity of the extracted signal with the TE11 envelope detector and the outer circumferential position information of the electromagnetic wave detector, a structure information output unit which outputs inside structure information of the gas-insulated equipment is provided; and the presence or absence of a partial discharge is determined from the intensity distribution of outer circumferential electromagnetic waves in the metal tank detected with the intensity detector and the inside structure information of the structure information output unit.

4: Electromagnetic Wave Detector
5: Moving Device
6: Displacement Angle Detector
7: Determining Section

Fig.1

**EP 2 063 276 A1**

**Description**

Technical Field

The present invention relates to a method of determining partial discharge and a system for determining partial discharge for determining whether or not a partial discharge occurs in gas-insulated equipment.

Background Art

A method of determining partial discharge of known gas-insulated equipment is disclosed in a non-patent document 1 by the inventors of the application concerned. This focuses attention on a TE11 mode in which a feature having a remarkable intensity distribution in an outer circumferential direction of an insulating spacer for particularly the gas-insulated equipment can be significantly used from higher TE modes on the basis of research results in which electromagnetic waves propagating in the gas-insulated equipment are analyzed and verified in detail in mode level; and this TE11 mode is set as a detection region.

Verification in which the presence of an electromagnetic wave in TE11 mode is certain is made by the remarkable outer circumferential intensity distribution of the insulating spacer of the gas-insulated equipment, and a mode change at the time when the electromagnetic wave in the aforementioned mode propagates in the gas-insulated equipment is also traced; and accordingly, it becomes possible to diagnose more surely and sophisticatedly.

In the known method disclosed in the non-patent document 1, an electromagnetic wave generated in a tank due to partial discharge propagates in a metal tank, and the electromagnetic wave leaked outside is detected. This constructs a detecting method and a detecting system by assuming gas-insulated switchgear (referred to as GIS) as a simple straight pipe, L shaped, and T shaped structure, and by using a result in which an electric field intensity distribution in the gas-insulated equipment is verified in mode level.

However, in actual GINS, its shape is not simple, there exists a convex and concave structure such as a post spacer for supporting a center conductor and an electric field shield in the tank where electromagnetic waves propagate; and therefore, there is a case where a mode change generated at such area is different from a concept shown in the Non-Patent Document 1. Therefore, there is an apprehension that an erroneous determination is made in the actual equipment when determination is made by only the method disclosed in the Non-Patent Document 1.

| | |
|---|---|
| Patent document 1: | Specification of Japanese Patent Application No. 2005-084305 filed on March 23, 2005 |
| Non-patent document 1: | S. Okabe Et al, "Method of diagnosing partial discharge using Electromagnetic wave mode conversion in GIS," the Journal of the Institute of Electrical Engineers of Japan (IEEJ) Transactions on Power and Energy 2005, Letter No. 331 |

DISCLOSURE OF THE INVENTION

PROBLEM TO BE SOLVED BY THE INVENTION

The present invention has been made to solve the problem described above, and an object of the present invention is to provide a method of determining partial discharge and a system for determining partial discharge with high accuracy adapted to more actual gas-insulated equipment while setting a TE11 mode in which a feature having a remarkable intensity distribution in an outer circumferential direction of an insulating spacer for particularly the gas-insulated equipment can be significantly used in a method of determining partial discharge and a system for determining partial discharge for tracing a mode change at the time when an electromagnetic wave propagates in the gas-insulated equipment, as a detection region; and while taking an actual internal construction of the gas-insulated equipment into account by further adding a verified result with respect to the internal construction of the gas-insulated equipment to research results in which electromagnetic waves propagating in the gas-insulated equipment are analyzed and verified in detail in mode level.

MEANS FOR SOLVING THE PROBLEM

A method of determining partial discharge according to the present invention, wherein as gas-insulated equipment, which is configured so that a cylindrical metal tank sealed with insulating gas is partitioned by insulating spacers and a center conductor is supported by the insulating spacers, is to be observed for determining the presence or absence of a partial discharge generated in the metal tank, the method includes the following steps:

2

detecting an electromagnetic wave signal at a plurality of outer circumferential positions of the insulating spacer with an electromagnetic wave detector, the electromagnetic wave signal propagating in the mental tank;

extracting a signal of a frequency band in which a TE11 mode propagates but a TE21 mode does not propagate by utilizing a cutoff frequency from the detected electromagnetic wave signal, with a TE11 envelope detector; and

determining a partial discharge by detecting an intensity distribution of outer circumferential electromagnetic waves in the metal tank with an intensity detector from the intensity of the extracted signal with the TE11 envelope detector and the outer circumferential position information of the electromagnetic wave detector.

The method includes a structure information output unit which outputs inside structure information of the gas-insulated equipment; and the step of determining the presence or absence of a partial discharge from the intensity distribution of the outer circumferential electromagnetic waves in the metal tank detected with the intensity detector and the inside structure information of the structure information output unit.

Further, in the method of determining partial discharge according to the present invention, the metal tank has an L shaped bent part; and the metal tanks extending in two directions from the bent part are respectively provided with the insulating spacers. The method includes the step of determining that a partial discharge occurs in the L shaped metal tank when the outline and inside structure information of the gas-insulated equipment obtained from the structure information output unit defines a plane including axis lines of the L shaped metal tank as a reference plane and when a structure is connected to the center conductor at the bent part in parallel to the reference plane and the structure is not a point-symmetric configuration centered on an axial point of the center conductor and in the case where an intensity distribution having two peak values in a direction substantially parallel to the reference plane at one insulating spacer is confirmed and an intensity distribution having two peak values in a direction substantially parallel to the reference plane at the other insulating spacer is confirmed.

Furthermore, a system for determining partial discharge according to the present invention is disclosed, wherein as gas-insulated equipment, which is configured so that a cylindrical metal tank sealed with insulating gas is partitioned by the insulating spacers and a center conductor is supported by the insulating spacers, is to be observed for determining the presence or absence of a partial discharge generated in the metal tank, wherein the system includes:

an electromagnetic wave detector for detecting an electromagnetic wave signal at a plurality of outer circumferential positions of the insulating spacer, the electromagnetic wave signal propagating in the metal tank;

a TE11 envelope detector for extracting a signal of a frequency band in which a TE11 mode propagates but a TE21 mode does not propagate by utilizing a cutoff frequency from the detected electromagnetic wave signal; and

an intensity detector for detecting an intensity distribution of outer circumferential electromagnetic waves in the metal tank from the intensity of the extracted signal with the TE11 envelope detector and the outer circumferential position information of the electromagnetic wave detector. The system includes a structure information output unit which outputs inside structure information of the gas-insulated equipment.

EFFECT OF THE INVENTION

According to a method of determining partial discharge or a system for determining partial discharge of the present invention, a structure information output unit which outputs inside structure information of gas-insulated equipment is provided; and therefore, it can be specified with high accuracy whether or not a partial discharge exists in the gas-insulated equipment from an intensity distribution of outer circumferential electromagnetic waves in a metal tank detected with an intensity detector and the inside structure information of the structure information output unit.

In addition, according to a method of determining partial discharge or a system for determining partial discharge of the present invention, a structure information output unit which outputs outline and inside structure information of gas-insulated equipment is provided; and therefore, it can be specified with high accuracy whether or not a partial discharge exists in the gas-insulated equipment from an intensity distribution of outer circumferential electromagnetic waves in a metal tank detected with an intensity detector and the outline and inside structure information of the structure information output unit.

The foregoing and other objects, features, aspects and advantages of the present invention will become more apparent from the following detailed description of the present invention when taken in conjunction with the accompanying drawings.

BRIEF DESCRIPTION OF THE DRAWINGS

Fig. 1 is a configuration view in which a system for determining partial discharge according to Embodiment 1 of the present invention is mounted on gas-insulated equipment.

Fig. 2 is a cross-sectional configuration view seen from the arrow direction indicated by Q-Q as shown in Fig. 1.

Fig. 3 is a view showing an intensity distribution of circumferential electromagnetic wave appeared when a partial discharge occurs in an L shaped tank according to Embodiment 1.

Fig. 4 is a view showing an intensity distribution of circumferential electromagnetic wave appeared when a partial discharge occurs in an L shaped tank according to Embodiment 2.

Fig. 5 is a view showing an intensity distribution of circumferential electromagnetic wave appeared when a partial discharge occurs in a straight pipe tank according to Embodiment 3.

Fig. 6 is a view showing an intensity distribution of circumferential electromagnetic wave appeared when a partial discharge occurs in the straight pipe tank according to Embodiment 3.

Fig. 7 is a view showing an intensity distribution of circumferential electromagnetic wave appeared when a partial discharge occurs in a T shaped tank according to Embodiment 4.

Fig. 8 is a view showing an intensity distribution of circumferential electromagnetic wave appeared when a partial discharge occurs in the T shaped tank according to Embodiment 4.

Fig. 9 is a view showing an intensity distribution of circumferential electromagnetic wave appeared when a partial discharge occurs in a T shaped tank according to Embodiment 5.

Fig. 10 is a view showing an intensity distribution of circumferential electromagnetic wave appeared when a partial discharge occurs in the T shaped tank according to Embodiment 5.

Fig. 11 is a configuration view in which a system for determining partial discharge according to Reference Example 1 is mounted on gas-insulated equipment,

Fig. 12 is a cross-sectional configuration view seen from the arrow direction indicated by P-P as shown in Fig. 11.

Fig. 13 is a typical view showing an electromagnetic field distribution of a TEM mode, TE11 mode, and TE21 mode in a coaxial line.

Fig. 14 is a view showing an example of an intensity distribution of electromagnetic wave when a partial discharge occurs in a tank.

Fig. 15 is a view for explaining a method of determining partial discharge of a straight pipe tank according to Reference Example 1.

Fig. 16 is a view showing another example of a determining section of the system for determining partial discharge of Fig. 11.

Fig. 17 is a view showing one example of an intensity distribution pattern obtained by the determining section of Fig. 16.

Fig. 18 is a view for explaining a method of determining partial discharge of an L shaped tank according to Reference Example 2.

Fig. 19 is a view showing another example for explaining a method of determining partial discharge of the L shaped tank according to Reference Example 2.

Fig. 20 is a view showing a further other example for explaining a method of determining partial discharge of the L shaped tank according to Reference Example 2.

Fig. 21 is a view for explaining a method of determining partial discharge of a T shaped tank according to Reference Example 3.

Fig. 22 is a view showing another example for explaining a method of determining partial discharge of the T shaped tank according to Reference Example 3.

Fig. 23 is a view showing other example for explaining a method of determining partial discharge of the T shaped tank according to Reference Example 3.

Fig. 24 is a view showing a further other example for explaining a method of determining partial discharge of the T shaped tank according to Reference Example 3.

DESCRIPTION OF REFERENCE NUMERALS

1     = Metal tank

2 = Insulating spacer
3 = Center conductor
4 = Electromagnetic wave detector
5 = Moving device
6 = Displacement angle detector
7 = Determining section
8 = TE11 envelope detector
9 = Input section
10 = Intensity detector
11 = Determining device
12 = Guiding rail
13 = Partial discharge source
14 = Pattern recognition device
15 = Reference plane
16 = Reference plane
21 = Post spacer
22 = Pattern recognition device
23 = Detection pattern indicator
24 = Structure information output unit
25 = Assumption pattern indicator
26 = Electric field relaxation shield
27 = Bent part
28 = Branched part

## DETAILED DESCRIPTION OF THE INVENTION

As a previous step prior to explaining embodiments, the patent document 1 which is an earlier application of the application concerned will be described in detail as reference examples.

Reference Example I

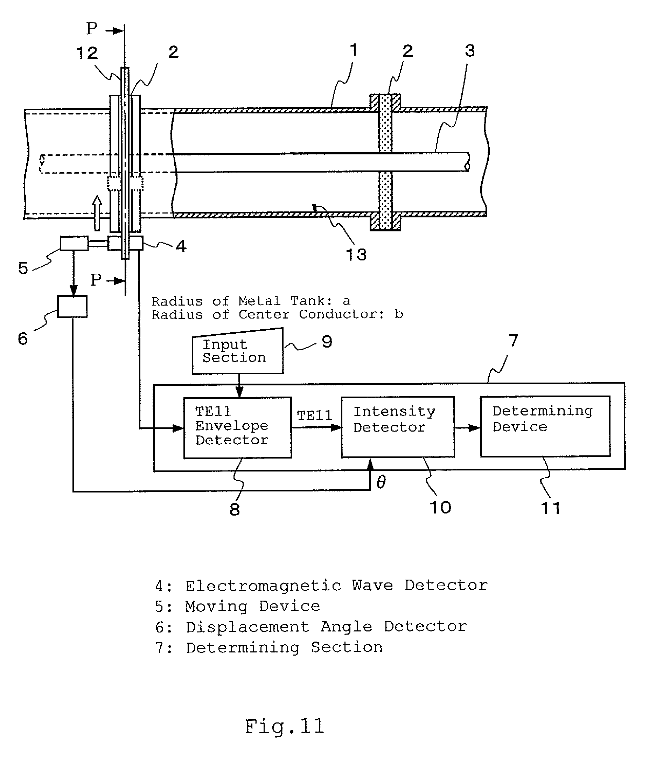

Fig. 11 is a configuration view in which a system for determining partial discharge according to Reference Example 1 is mounted on gas-insulated equipment. As an example of the gas-insulated equipment to be observed for determination, GIS (Gas Insulated Switchgear) will be described. GIS is configured so that it includes switchgear such as a disconnecting switch, a circuit breaker, and electrical equipment for protecting them, which are connected by bus lines, and a high voltage live part of each piece of equipment is accommodated in a metal tank filled with insulating gas. The Figure shows a case where the system for determining partial discharge is disposed in a bus line tank part of the GIS.
As shown in the Figure, the system is configured such that a plurality of cylindrically shaped metal tanks 1 are coupled via insulating spacers 2 and a cylindrical center conductor 3 supported by the insulating spacers 2 is coaxially disposed. Then, insulating gas is filled in the metal tank 1 partitioned by the insulating spacers 2. In addition, a "metal tank" is referred to as merely a "tank" below.
Next, the configuration of the system for determining partial discharge will be described. An electromagnetic wave detector 4 for detecting an electromagnetic wave signal which propagates in the tank 1 is disposed on an outer circumferential part of the insulating spacer 2 which couples the tank 1. The electromagnetic wave detector 4 is mainly formed of an electromagnetic wave antenna, for example, a loop coil, a dipole antenna, a log periodic antenna, a horn antenna or the like.
The electromagnetic wave detector 4 is movable along the outer circumferential direction of the insulating spacer 2 by a moving device 5, and an electromagnetic wave can be measured at any position in the outer circumferential direction to detect it. Position information of the electromagnetic wave detector 4 when the electromagnetic wave detector 4 is moved along the outer circumferential direction of the insulating spacer 2 by the moving device 5 is sent to a displacement angle detector 6 to be detected as a displacement angle $\theta$ from a reference point.
A detection signal from the electromagnetic wave detector 4 and displacement angle information from the displacement angle detector 6 are transmitted to a determining section 7. The determining section 7 includes:

a TE11 envelope detector 8 for extracting the electromagnetic wave signal of a frequency band in which a TE11 mode propagates but a TE21 mode does not propagate by utilizing a cutoff frequency, to be described later, from a detection signal of the electromagnetic wave detector 4;
an input section 9 for inputting outer diameter information of the tank 1 and the center conductor 3 necessary for computing the cutoff frequency;
an intensity detector 10 for detecting an intensity distribution of electromagnetic waves in the outer circumferential direction of the tank 1 by receiving an output signal from the TE11 envelope detector 8 and the displacement angle θ of the displacement angle detector 6; and
a determining device 11 for determining the presence or absence of a partial discharge by comparing the detected intensity distribution with an intensity distribution peculiar to the TE11 made. The above-mentioned reference numerals 4 to 11 constitute essential parts of the system for determining partial discharge. In addition, for example, a foreign particle or the like in the tank may act as a partial discharge source 13.

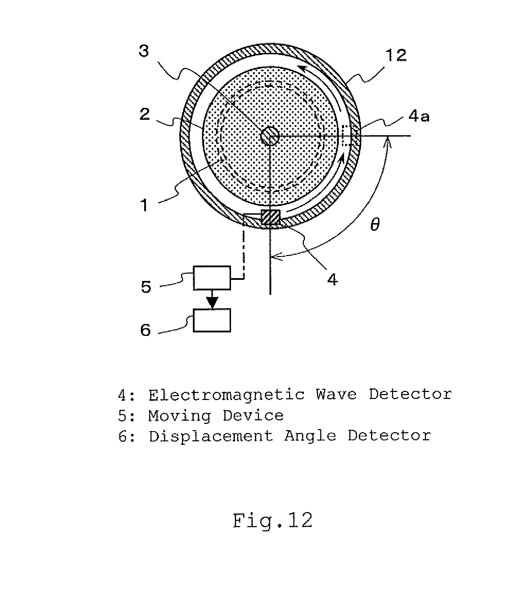

Fig. 12 is a cross-sectional configuration view seen from arrow direction of P-P shown in Fig. 11 and shows an example when the electromagnetic wave detector 4 is made to move by the moving device 5. As shown in the Figure, a guiding rail 12 is provided on the outer circumferential part of the insulating spacer 2 so as to slidably engage the guiding rail 12 with an engaging part provided on the electromagnetic wave detector 4. A drive motor is provided on the electromagnetic wave detector 4 so as to move on the guiding rail 12 by a command from the moving device 5. The position information in the circumferential direction at this time is extracted to the displacement angle detector 6. For example, if the position of the perpendicular bottom part of the Figure is the reference point, θ is detected as the displacement angle when measurement is performed at a position 4a.
In addition, the moving device shown in Fig. 12 is an example, and it is not limited to the configuration shown in the Figure as long as it can move in the outer circumferential direction of the insulating spacer 2.

Next, a method for detecting partial discharge by the system for determining partial discharge will be described. The bus line tank of the GIS, as shown in Fig. 11, is of a coaxial structure composed of the center conductor 3 and the tank 1 which surrounds it. An electromagnetic wave mode which propagates in such a coaxial structure includes a TEM mode, a TE mode (TE11, TE21, TE31...), and a TM mode; each mode represents a different propagation form of electromagnetic waves and is distinguished by the presence or absence of an electric field and magnetic field vector with respect to the direction of propagation. It is known that the TEM, TE11 mode, TE21 mode... exist in limited areas not lower than a specific frequency for each mode.
Such a specific frequency is a so-called cutoff frequency and is determined according to the shape and size of configuration elements, such as the center conductor diameter, the tank diameter, or the like, that is, according to the shape and size of the gas-insulated equipment. For example, when the radius of the tank 1 is **a**, the radius of the center conductor 3 is **b**, and the velocity of light is **c**, the cutoff frequency f of the TEm1 mode is approximately represented by Equation (1).

$$F = c \cdot m / [(\pi (a + b)] \qquad ....\text{Equation (1)}$$

where m = 1, 2, 3 ...
In other words, if the shapes of the tank 1 and the center conductor 3 are determined, an existing mode and the cutoff frequency can be specified.
Of the respective modes, the TEM mode is an electric field distribution that is the same as a static electric field that has no peak distribution in the circumferential direction of the tank. On the other hand, the TE(ml) mode denotes the electric field distribution that has a peak distribution in the circumferential direction.

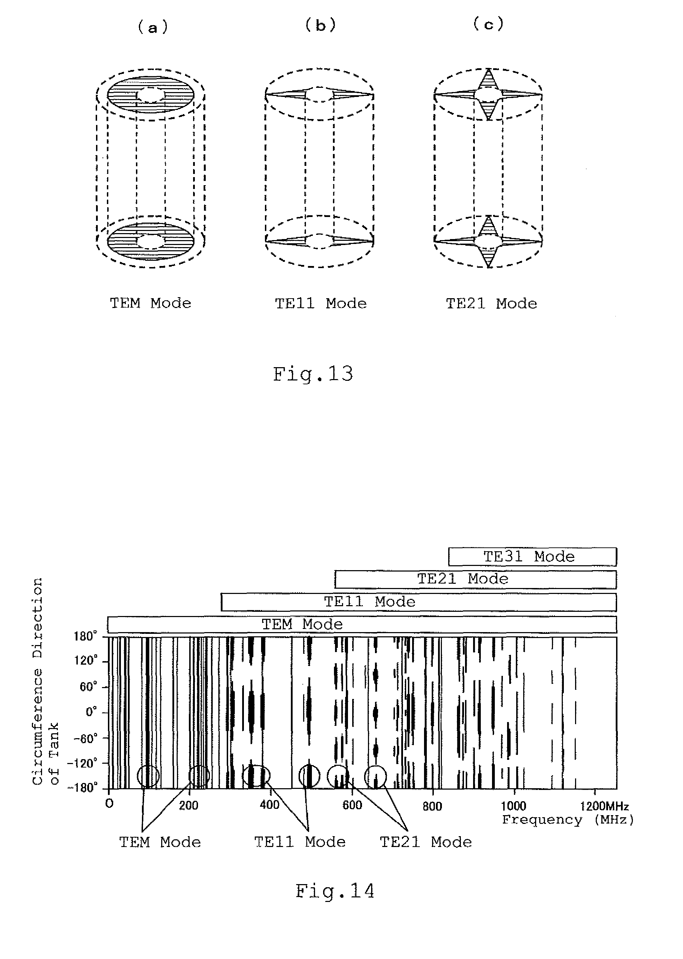

Fig. 13 is a typical view showing the electromagnetic field distribution of the TEM mode, the TE11 mode, and the TE21 mode in a coaxial line. As shown in the Figure, the TE11 mode denotes an electric field distribution having strong peaks at circumferential positions of 180° symmetry; the TE21 mode denotes an electric field distribution having peaks at circumferential positions of 90° symmetry.
Fig. 14 is a view showing an example of the intensity distribution of an electromagnetic wave when a partial discharge occurs in the tank. The contrast between the electromagnetic wave intensity of each frequency and the distribution state in the wall surface of the tank is represented in shading. This Figure is an example of experimental validation data cleared by investigation by the inventors, which shows a partial discharge generated in a tank with a 2 m long center conductor.
The vertical axis shows the outer circumferential position on the tank as an angle by defining the discharge source as a reference point (0°), and the horizontal axis shows frequency (MHz). In the Figure, parts in deep shade represent strong parts of the electromagnetic wave signal. Above the Figure, a frequency band in which each electromagnetic wave signal of the TEM mode, TE11 mode, TE21 mode, and TE31 mode propagates is shown by a horizontal bar chart.
As illustrated by circles in the Figure, it is well known that the TEM mode has signals uniformly in the circumferential direction without having a peak value; the TE11 mode has two strong peaks at the 180° opposing positions in the circumferential direction; and the TE21 mode has four peaks at intervals of 90°. Therefore, if such an intensity distribution is verified in the frequency region of each mode computed by using Equation (1), it indicates that there is absolutely an electromagnetic wave of its mode.

As described above, electromagnetic waves due to partial discharge are broadly distributed in the GIS from the TEM region to that of mode signals of a higher order. It becomes possible to determine the presence or absence of a partial discharge in the GIS by obtaining the distribution shape. Here, a mode to be focused on needs to be determined by taking account of the ease of distinguishing the pattern and the ease of processing the signal. Regarding the ease of processing the signal, although it is preferable to select a lower frequency band as a detection target, it is difficult to find a characteristic distribution pattern because the TEM mode existing at the lowest frequency is distributed in all circumferential directions.

On the other hand, in the case of a higher order mode, since the shape of the distribution is complicated, it is possible to find a pattern peculiar to the GIS which does not exist in nature; however, if it is too complicated, the determining algorithm for the system for determining partial discharge becomes very sophisticated and complicated and processing of a high frequency signal also becomes difficult; thus it is not suitable for actual diagnosis.

Therefore, in this case, this example focuses on the TE11 mode, in which a feature relatively peculiar to the GIS can be found, and an area in which signal processing is easy. In addition, the frequency band of the TE11 mode for an actual GIS tank according to a trial calculation using Equation (1) is approximately 200 MHz to 1 GHz, though it differs according to the tank diameter.

The frequency band, which is previously described in that the electromagnetic wave signal of the frequency band in which the TE11 mode propagates but the TE21 mode does not propagate is extracted by utilizing a cutoff frequency with the TE11 envelope detector 8 shown in Fig. 11, has a range not lower than the cutoff frequency of the TE11 mode calculated according to Equation (1) and less than the cutoff frequency of the TE21 mode.

In this regard, Equation (1) is an approximate equation and the mode cannot be completely distinguished by this equation, and therefore, the range need not to be strictly delimited and some tolerance may be provided at the front and back. For actual usage, it is practical to have some tolerance from the view point of versatility.

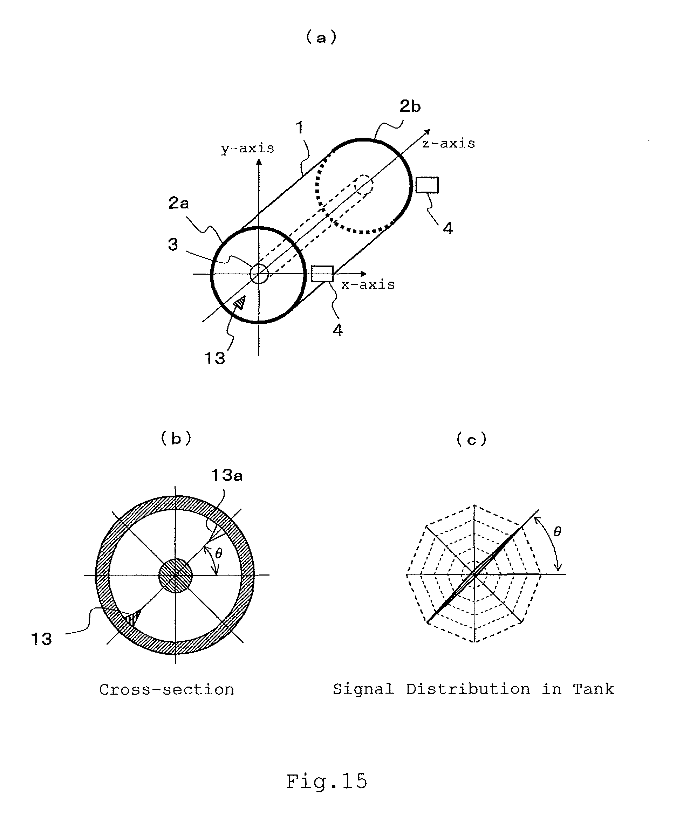

Next, a specific determining method in the gas-insulated equipment will be described. Fig. 15 is a view for explaining a method of determining partial discharge using the system for determining partial discharge of Reference Example 1. Fig. 15(a) shows an occurrence position when a partial discharge occurs in the tank 1 formed of a straight pipe, which is partitioned by two insulating spacers 2a and 2b; Fig. 15(b) is a cross-sectional view in a direction perpendicular to the z-axis of the occurrence position of the partial discharge and shows the case where the partial discharge source 13 exists at a position at an angle θ when the horizontal direction is set as a reference, for example. Further, Fig. 15(c) shows the intensity distribution of an electromagnetic wave in the circumferential direction when the electromagnetic wave signal due to partial discharge is observed at the insulating spacers 2a or 2b provided at connection parts of the straight pipe tank 1.

In addition, the partial discharge source 13 is shown adjacent to the insulating spacer for the sake of facilitating understanding, but it may be placed at any location in the tank 1. Further, the intensity distribution of an electromagnetic wave signal is shown by simplifying in order to clearly visually describe the direction and shape that the peak mainly takes, and therefore, it does not correctly represent the actual measurement value.

The following description is also similar to the above description. Measurement of partial discharge is performed at a plurality of outer circumferential positions while the electromagnetic wave detector 4 is moved by the moving device 5 along the outer circumferential direction of the insulating spacer 2a. At this time, information of the measurement position from the reference point is detected by the displacement angle detector 6 as angle information θ, and transmitted to the determining section 7 of the system for determining partial discharge.

When the partial discharge source 13 generated in the GIS tank exists, for example, at the position at the angle θ when the horizontal direction is set as the reference (13a opposing 13 by 180° is also the same), the electromagnetic wave signal is also strongly radiated in the direction of the angle θ; thus, in the insulating spacer 2a, a distribution having a strong signal peak at substantially the angle θ is confirmed as shown in Fig. 15(c) of the Figure.

Consequently, if the electromagnetic wave signal from the electromagnetic wave detector 4, measured at a plurality of outer circumferential positions of the insulating spacer 2a, is extracted to the determining section 7 of the system for determining partial discharge as shown in Fig. 11, to represent as an outer circumferential intensity distribution by performing signal processing, a strong peak value is found at the position opposing by substantially 180° when electromagnetic waves of the TE11 mode exist, that is, when the electromagnetic waves are due to partial discharge. Therefore, the presence or absence of a partial discharge can be determined depending on whether or not the intensity distribution of the detected result is indicative of a distribution peculiar to the TE11 mode.

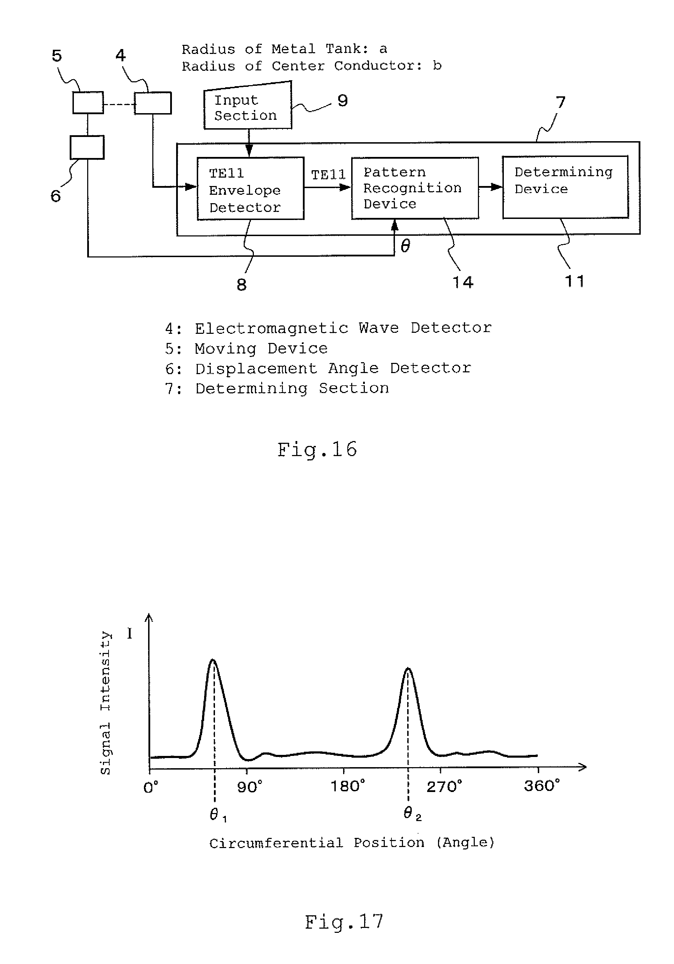

A pattern recognition device, which is used as a specific example of the intensity detector 10, will be described. Fig. 16 is a block diagram when a pattern recognition device 14 is used as the intensity detector of the system for determining partial discharge shown in Fig. 11. Since the further components other than the pattern recognition device 14 are the same as in Fig. 11, their description will not be repeated.

When a TE11 signal from the TE11 envelope detector 8 and information of the displacement angle θ from the displacement angle detector 6 are input to the pattern recognition device 14, the pattern recognition device 14 generates an intensity distribution pattern of the electromagnetic wave signal on the outer circumference of the insulating spacer 2.

An example of the intensity distribution pattern is shown in Fig. 17. The vertical axis of the Figure is the signal intensity, the horizontal axis is the circumferential position (angle), and the signal intensity at each position is graphed, resulting in an intensity distribution pattern shown by the thick line. The determining device 11 determines, for example, whether or not a mode is peculiar to the TE11 mode from the interval between θ1 and θ2 and the peak values.

If remarkable peak values such as θ1 and θ2 are confirmed at positions substantially opposing each other by 180°, it can be determined that the distribution is peculiar to the TE11 mode, and therefore, it can be determined that the electromagnetic waves due to partial discharge are detected. As described, in the measurement in the outer circumferential direction of the insulating spacer 2, it can be specified that there is no external noise but there exists a partial discharge inside by confirming, in a reproducible fashion, that two peaks exist at positions spaced by substantially 180°. In addition, the pattern recognition device can use various kinds of signal processing techniques generally available at present.

Further, as shown in Fig. 15(a), in the case where the insulating spacer 2a and the insulating spacer 2b are disposed at both ends of the tank 1, when the partial discharge source 13 exists in the insulated compartment, a distribution shape having two peaks, like that described above, propagates to both sides without losing its shape if a straight pipe tank is used; and therefore, the peak values appear at the same positions of the adjacent insulating spacers 2a and 2b.

Consequently, in the case where two or more insulating spacers exist in the straight pipe tank 1, when a signal of the TE11 mode having peaks at positions of 180° symmetry in the circumferential direction is detected and the peak values are confirmed at the same positions at the adjacent insulating spacer 2b, the signal detected by the electromagnetic wave detector 4 can be determined as a partial discharge signal in the tank 1. When the both peak positions are different, the signal is not being due to a partial discharge, but determined as external noise.

Further, as described above, the peak signal appears in the same direction as the circumferential position of the partial discharge source 13. By using this fact, the circumferential position of the partial discharge source 13 can be estimated by position (angle) information of the circumferential position of the tank 1 at which the detected peak signal appears. In this regard, in Fig. 15(b), it cannot be determined whether the partial discharge source appears at 13 or 13a, nor whether it appears at the tank 1 side or the center conductor 3 side.

The description so far concerns the case where, as a method of measuring at a plurality of outer circumferential positions of the insulating spacer 2 using the electromagnetic wave detector 4, the measurement position is moved by using the moving device 5. However, for example, a measurement operator may measure while moving the electromagnetic wave detector 4 along the outer circumferential direction of the insulating spacer 2 without depending on the moving device 5. Further, the position (angle) information need not be automatically extracted from the displacement angle detector 6; the measurement operator may input the information to the intensity detector 10.

Further, in order to compute the cutoff frequency, diameter information of the tank 1 and the center conductor 3 is input from the input section 9. However, the information need not be input in each case; but, it may be stored in advance in a memory unit, or a cutoff frequency computed from diameter information may be directly used when the gas-insulated equipment to be measured is specified.

Furthermore, when the presence or absence of a partial discharge is determined from the measurement result, at the stage where the intensity distribution is obtained by the intensity detector, it is possible, for a person of skill in the art, to determine the presence or absence of a partial discharge by observing the intensity distribution without using the determining device at a subsequent stage. For example, if the pattern recognition device described above is used as the intensity detector and the result is displayed visually as the intensity distribution pattern, the presence of the TE11 mode can be confirmed from the Figure. Therefore, the determining device 11 in the determining section 7 is not required as the system for determining partial discharge.

As described above, according to Reference Example 1, the device performs: detecting an electromagnetic wave signal at a plurality of outer circumferential positions of an insulating spacer; extracting a signal of a frequency band in which a TE11 mode propagates but a TE21 mode does not propagate with a TE11 envelope detector; detecting an intensity distribution of an outer circumferential electromagnetic waves in a tank from the intensity of the extracted signal and the circumferential position information of an electromagnetic wave detector; and determining the presence or absence of a partial discharge depending on whether or not the intensity distribution is indicative of a distribution peculiar to the TE11 mode.

Therefore, a signal of the TE11 mode included in an electromagnetic wave caused by a partial discharge can be effectively captured and a feature peculiar to the mode can be extracted, thereby enabling the provision of a method of determining partial discharge or a system for determining partial discharge which can determine the presence or absence of a partial discharge with high reliability, without being affected by external noise.

Further, determination of the presence or absence of a partial discharge is performed by comparing the intensity distribution of the electromagnetic wave obtained by the intensity detector using the determining device with a distribution peculiar to the TE11 mode, and therefore, more accurate determination can be performed in addition to the above-mentioned effects.

Furthermore, intensity distributions of electromagnetic waves, respectively measured at two insulating spacers mounted in the axial direction of a straight pipe tank, are compared to determine that a partial discharge occurs in the straight pipe if peak positions of both intensity distributions are the same; therefore, the presence or absence of a partial discharge in the straight pipe tank can be accurately determined.

Reference Example 2

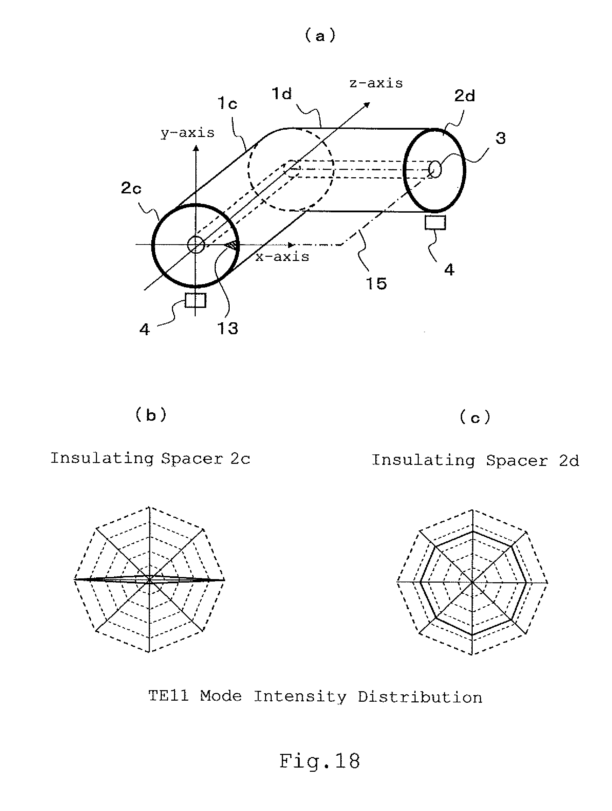

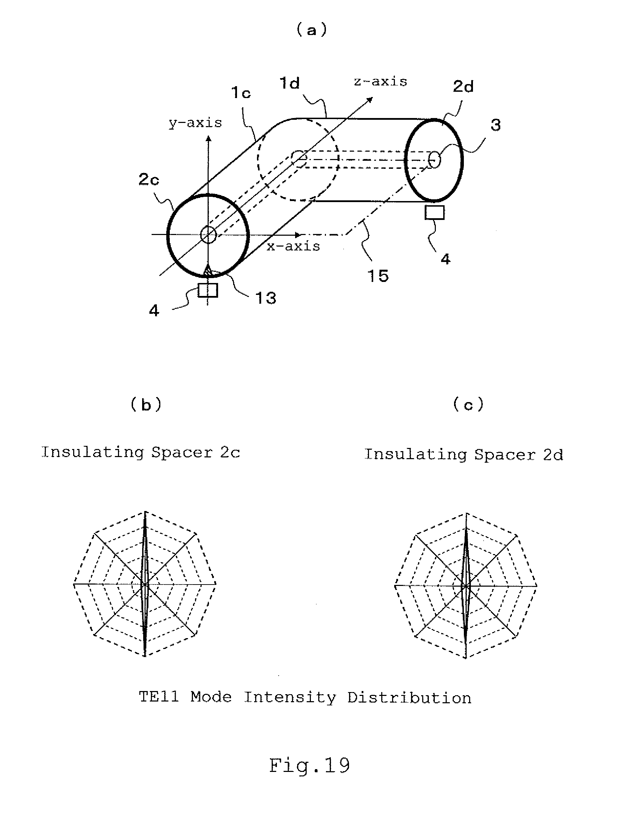

Fig. 18 to Fig. 20 are views for explaining a method of determining partial discharge according to Reference Example 2. Fig. 18(a) and Fig. 19(a) show occurrence positions of partial discharges in an L shaped tank; Fig. 18(b) and Fig. 19(b) show the intensity distributions of electromagnetic waves at an insulating spacer at one side; and Fig. 18 (c) and Fig. 19(c) show the intensity distributions of electromagnetic waves at an insulating spacer at the other side. As shown in the Figures, insulating spacers 2c and 2d are respectively disposed behind and in front of an L shaped bent part with respect to L shaped tanks 1c and 1d. Since the configuration other than the L shaped tanks 1c and 1d is equivalent to Fig. 11 described in Reference Example 1, and the system for determining partial discharge is equivalent to the Figures described in Reference Example 1, a detailed description thereof will not be repeated, and a description mainly about the points of difference will be given.

In the case where the GIS is configured by a straight pipe tank, the behavior of the electromagnetic waves is simple as described in Reference Example 1; however, since an actual GIS is configured by combining a plurality of L shaped or T shaped tanks, conversion of the electromagnetic wave mode occurs at the L shaped or T shaped bent parts, and the shape of circumferential distribution of the signal is lost.

First, as shown in Fig. 18, the case where a partial discharge source 13 exists in the tank 1c at the front side of the L shaped bent part will be described. In order to specify a direction in the Figure, a plane including axis lines of the tanks 1c and 1d is set as a reference plane 15. The case where the partial discharge source 13 is located on the tank 1c side at a position which passes through the axis center in the direction (x-axis direction) parallel to the reference plane 15 will be described.

In this case, in the insulating spacer 2c, the intensity distribution of the TE11 mode having a peak value in the direction (x-axis direction) parallel to the reference plane 15, like Fig. 18(b) of the Figure, is confirmed. Then, it is confirmed by investigation by the inventors that, in the insulating spacer 2d after passing the L shaped part, the intensity distribution appeared in all the circumferential directions, as shown in Fig. 18(c) of the Figure, unlike the distribution in 2c. As a result, in the case where the insulating spacers 2c and 2d exist behind and in front of the bent part of the L shaped tank, when the electromagnetic wave intensity distribution of the TE11 mode is measured with the electromagnetic wave detector 4 at both insulating spacers 2c and 2d, and two peak values exist in the direction substantially parallel to the reference plane 15 at the insulating spacer 2c on one side, it can be determined that a partial discharge, not external noise, occurs in the tank if it can be confirmed that the distribution reproducibly exists in all circumferential directions at the insulating spacer 2d on the other side. Therefore, the presence or absence of a partial discharge occurred at a position parallel to the reference plane in the circumferential direction in the L shaped tank can be accurately determined.

Next is the case where the partial discharge source 13 is located in the tank 1c at a position which passes through the axis center in the direction (y-axis direction) perpendicular to the reference plane 15, as shown in Fig. 19 (a) which is of the L shaped tank similar to Fig. 18. At this time, the electromagnetic waves of the TE11 mode due to the partial discharge observed at the insulating spacer 2c have peak values in the direction (y-axis direction) perpendicular to the reference plane 15, as shown in Fig. 19(b) of the Figure; as shown in Fig. 19(c) of the Figure, a signal distribution having peak values in the direction perpendicular to the reference plane 15 is confirmed, even in a signal observed at the insulating spacer 2d after passing the L shaped bent part.

From this result, in the case where the insulating spacers 2c and 2d exist on both sides of the L shaped tank 1c and 1d, when the electromagnetic wave circumferential intensity distribution of the TE11 mode is measured with the electromagnetic wave detector 4 at both the insulating spacer parts, and two peak values exist in the direction substantially perpendicular to the reference plane 15 at the insulating spacer 2c on one side, it can be determined that a partial discharge occurs in the tank if it can be confirmed that, similarly, two peak values reproducibly exist in the perpendicular direction at the insulating spacer 2d on the other side.

Therefore, the presence or absence of a partial discharge occurred at a position perpendicular to the reference plane in the circumferential direction in the L shaped tank can be accurately determined.

The description so far is of the case where the partial discharge signal enters in the direction parallel or perpendicular to the reference plane 15. Next, the case where the partial discharge source 13 is located in a direction oblique to the reference plane 15 will be described. It is confirmed that, in the case where the signal enters in an oblique direction, the oblique signal is considered to be separated into a horizontal component and a vertical component and this will be described next.

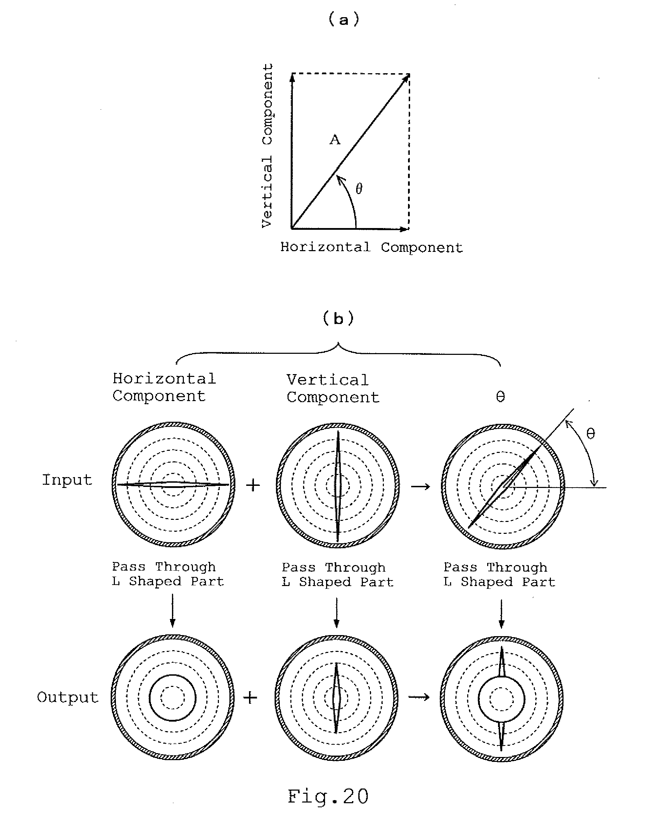

Fig. 20 is a view for explaining the variation of the TE11 mode electromagnetic wave distribution at the L shaped bent part when the partial discharge source 13 exists in a direction oblique to the reference plane. As shown in Fig. 20 (a) of the Figure, in the case where the partial discharge source 13 exists at a position of an angle θ with reference to a horizontal direction (the reference plane), a distribution having strong signal peaks is confirmed that the partial discharge source 13 exists at a position of the angle θ as the sum of the horizontal component and the vertical component at the insulating spacer 2c of the metal tank 1c side, as shown by "input" in Fig. 20(b) of the Figure.

This can be considered as a result of the sum of the horizontal component (A cos θ) and the vertical component (A sin θ) into which the signal having amplitude A, entering at angle θ, is divided. On the other hand, at the insulating spacer 2d side after passing the L shaped bent part, as shown by "output" in Fig. 20(b) of the Figure, it is confirmed that a distribution like a bottom right mode, which is the sum of the result converted at respective bent parts of the horizontal component and the vertical component, appeared.

Consequently, in the actual measurement, in the case where outer circumferential distribution of the signal observed at the insulating spacers behind and in front of the L shaped bent part conforms to the distribution predicted here; that is, when an intensity distribution having two peak values in the oblique direction at the insulating spacer part on one side is confirmed, and an intensity distribution corresponding to the sum of the vertical direction component and the entire circumferential direction component is confirmed at the insulating spacer part on the other side, it can be determined that a partial discharge occurs in the tank. Therefore, the presence or absence of a partial discharge occurred at a position oblique to the reference plane in the circumferential direction in the L shaped tank can be accurately determined.

Reference Example 3

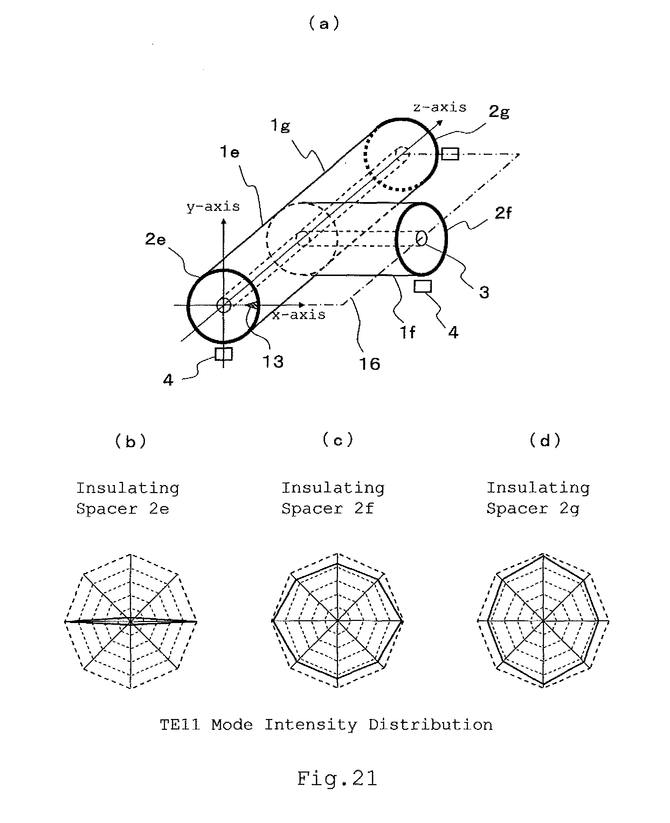

Fig. 21 to Fig. 24 are views for explaining a method of determining partial discharge according to Reference Example 3. Respective parts (a) of the Figures show occurrence positions where partial discharges in a T shaped tank; and parts (b) to (d) show the intensity distributions of electromagnetic waves at each insulating spacer. As shown in the Figures, the T shaped tank has a straight pipe part and a branch pipe part which is branched in a T shape in the middle of the straight pipe part and the tanks 1e, 1f, and 1g extending in three directions from the branched points are respectively provided with insulating spacers 2e, 2f, and 2g. Since the configuration other than the T shaped tank is equivalent to Fig. 11 described in Reference Example 1, and the system for determining partial discharge is equivalent to the Figures described in Reference Example 1, a detailed description thereof will not be repeated, and a description mainly about the points of difference will be given.

In order to specify a direction in the Figure, a plane including axis lines of the tanks 1e to 1g is set as a reference plane 16. First, as shown in Fig. 21, the case where the partial discharge source 13 is located on the tank 1e side at a position which passes through the tank axis center in a direction parallel to the reference plane 16 will be described. In the case where the partial discharge source 13 exists at a position as shown in the Figure, the signal distribution of the TE11 mode having two peaks in the direction (x-axis direction) parallel to the reference plane 16 at the insulating spacer 2e as shown in Fig. 21(b) is confirmed.

At this time, it is noted that, in the insulating spacer 2f on the branch pipe 1f side and the insulating spacer 2g on the straight pipe 1g side after passing the branched part, the intensity distribution having substantially the same level appear in all circumferential directions, as shown in Fig. 21(c) and Fig. 21(d) of the Figure, unlike the distribution in 2e. In addition, the case where the partial discharge source 13 is located in the same direction on the straight pipe 1g side is also similar.

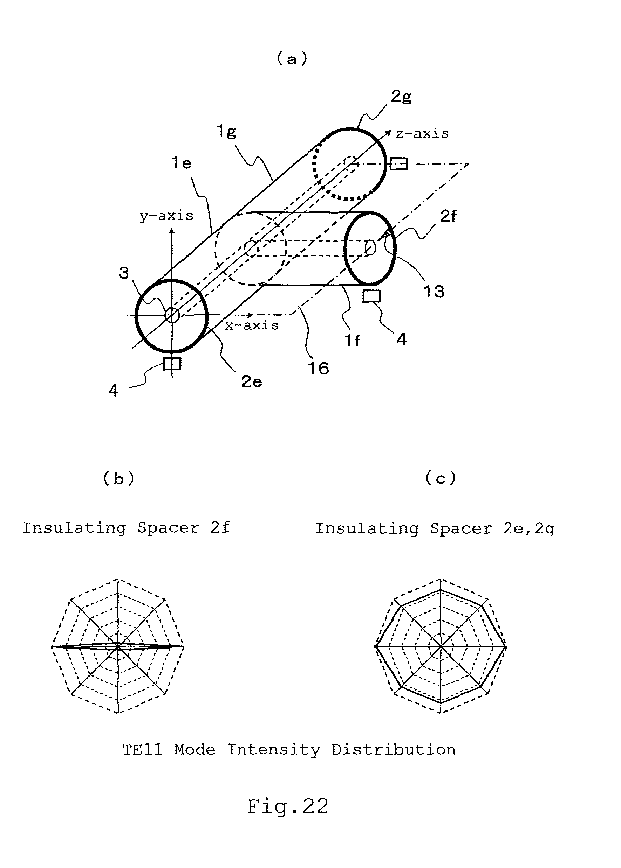

On the other hand, as shown in Fig. 22(a), it is noted that when the partial discharge source 13 exists in the branch pipe 1f side at a position which passes through the axis center in a direction (z-axis direction) parallel to the reference plane 16, the distribution having two peak values parallel to the reference plane is confirmed at the insulating spacer 2f as shown in Fig. 22(b); in the insulating spacer 2e on the straight pipe 1e side and the insulating spacer 2g on the straight pipe I g side after passing the branched part, the intensity distributions which have signals in the entire circumference in the circumferential direction appear, as shown in Fig. 22(c).

As a result, in the case where the T shaped tank is provided with insulating spacers on both sides of the straight pipe part and on the branch pipe side, and when the electromagnetic waves are detected with the electromagnetic wave detector 4 at the respective insulating spacers 2e to 2g to detect the frequency of the TE11 mode, which is deemed as the intensity distribution in the outer circumferential direction of the tank; it can be determined that a partial discharge occurs in the tank in the case where an intensity distribution having two peak values in a direction substantially parallel to the reference plane 16 at any one of the insulating spacer parts is confirmed and an intensity distribution having signals in the entire circumference at the other two insulating spacer parts is confirmed. Therefore, the presence or absence of a partial discharge occurred at a position parallel to the reference plane in the circumferential direction in the T shaped tank can be accurately determined.

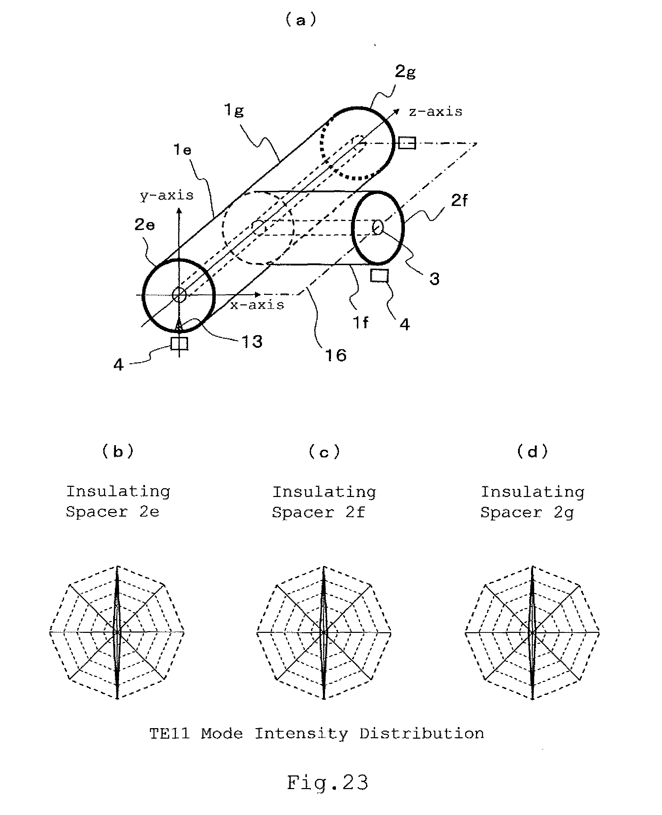

Next, the case where the partial discharge source 13 exists at a position which passes through the tank axis center in the direction (y-axis direction) perpendicular to the reference plane 16 will be described. This is the case where the partial discharge source 13 is located in the direction perpendicular to the reference plane 16 at the straight pipe 1e side of the T shaped tank as shown in Fig. 23(a).

In this case, in the insulating spacer 2e on the tank 1e side at which the partial discharge source 13 exists, the electromagnetic waves of the TE11 mode due to the partial discharge have two peak values in the direction perpendicular to the reference plane 16, as shown in Fig. 23(b); further, as shown in Fig. 23(c) and Fig. 23(d), it is confirmed that the electromagnetic wave signals have the intensity distribution having two peak values in the direction perpendicular to the reference plane 16, even in the case of the insulating spacer 2f on the branch pipe 1f side and the insulating spacer 2g on the straight pipe 1g side after passing the branched part.

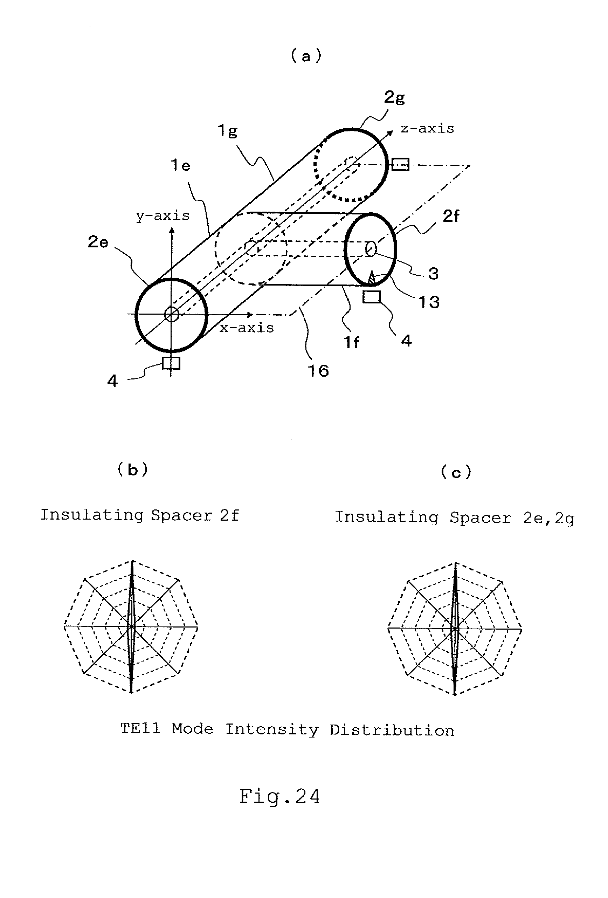

Similarly, as shown in Fig. 24(a), the case where the partial discharge source 13 exists at a position which passes through the axis center on the branch pipe 1f side in the direction perpendicular to the reference plane 16 will be described. In the insulating spacer 2f on the metal tank side at which the partial discharge source 13 exists, the electromagnetic waves of the TE11 mode due to the partial discharge have two peak values in the direction perpendicular to the reference plane 16, as shown in Fig. 24(b); it is confirmed that the electromagnetic wave signal, observed at the insulating spacers 2e and 2g which are provided with the straight pipe 1e and 1g after passing the branched part, has an intensity distribution having two peak values in the direction perpendicular to the reference plane 16, as shown in Fig. 24(c).

From these results, in the case where the insulating spacers are provided in three directions of the T shaped tank; when the electromagnetic wave signal detected with the electromagnetic wave detector 4 at the respective insulating spacers 2e to 2g is processed to obtain the intensity distribution in the outer circumferential direction of the tank, and two peak values in the direction substantially perpendicular to the reference plane 16 at either one of the insulating spacer parts exist; it is determined that a partial discharge occurs in the tank by confirming that two peak values reproducibly exist in the direction substantially perpendicular to the reference plane 16 similarly at the other insulating spacer parts, that is, by confirming that two peak values appears in the direction substantially perpendicular to the reference plane 16 at all the insulating spacer parts. Therefore, the presence or absence of a partial discharge occurred at a position perpendicular to the reference plane in the outer circumferential direction in the T shaped tank can be accurately determined.

For sake of simplicity, the description so far is of the case where the partial discharge source is located in the direction perpendicular or parallel to the reference plane 16. In the case where the partial discharge source exists in the direction oblique with respect to the reference plane 16, as in the case described in Reference Example 2, the intensity distribution of the TE11 mode can be obtained by dividing the oblique direction signal into a horizontal component and a vertical component and by superimposing each mode conversion result again.

Although not shown in the Figure, in the case where the partial discharge source 13 is located in a direction oblique with respect to the reference plane 16, it can be verified that an intensity distribution having two peak values in a direction substantially oblique with respect to the reference plane 16 at any one of three insulating spacer parts is confirmed and an intensity distribution corresponding to the sum of all circumferential direction components and a perpendicular direction component at the other two insulating spacer parts is confirmed.

Therefore, in the actual measurement, when the electromagnetic waves are detected with the electromagnetic wave detector 4 at each insulating spacer part of the T shaped tank, the intensity distribution of the electromagnetic wave of the TE11 mode in the outer circumferential direction of each insulating spacer part is obtained by signal processing, and its result represents the intensity distribution as described above; it can be determined that a partial discharge occurs in the tank and those other than that are external noise. Therefore, the presence or absence of a partial discharge occurred at a position in an oblique direction to the reference plane in the circumferential direction in the T shaped tank can be accurately determined.

Embodiment I

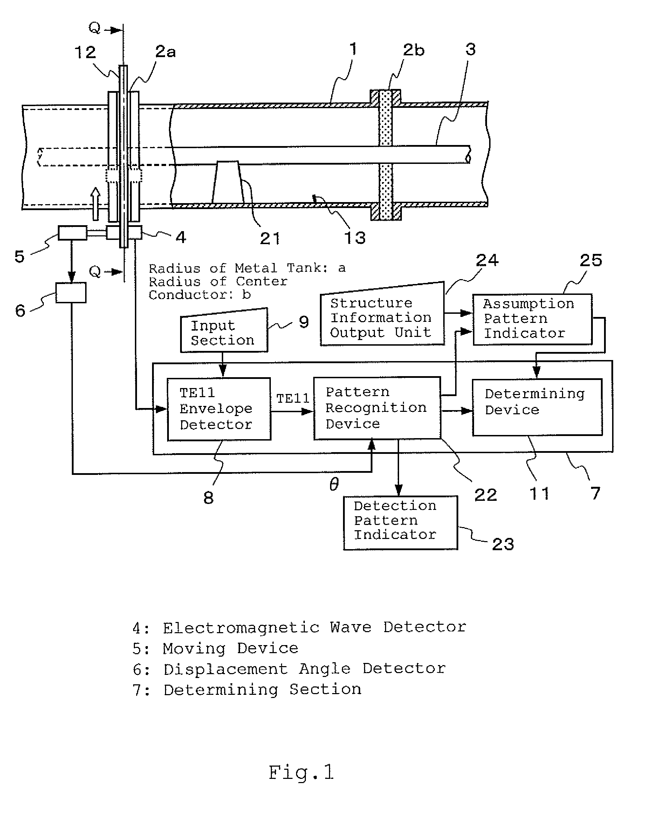

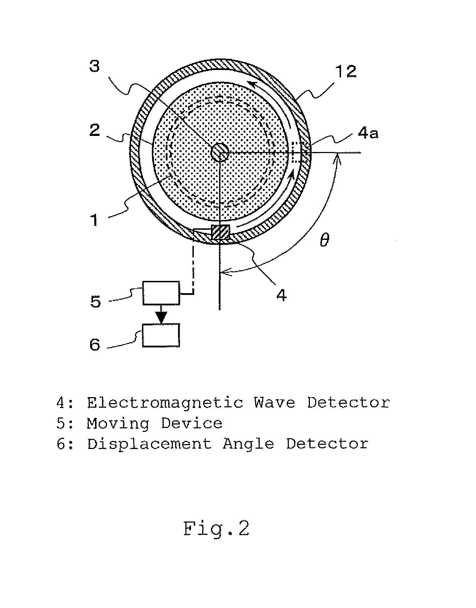

Fig. 1 is a configuration view in which a system for determining partial discharge according to Embodiment 1 of the present invention is mounted on gas-insulated equipment. Fig. 2 is a cross-sectional configuration view seen from arrow direction of Q-Q shown in Fig. 1. In respective Figures in the specification, the same reference numerals show identical or equivalent portions, and their description will be partly omitted.

The gas-insulated equipment is configured such that a plurality of cylindrically shaped tanks 1 are coupled via insulating spacers 2 and a cylindrical center conductor 3 supported by the insulating spacers 2 is coaxially disposed with the tank 1. Then, insulating gas is filled in the tank 1 partitioned by the insulating spacers 2. Basically, as shown in Fig. 1, GIS is of a coaxial structure composed of the center conductor 3 and the tank 1 that covers the center conductor; however, in some cases, a non-point symmetrically configured post spacer 21 centered on an axial point of the center conductor 3 is sometimes inserted to support the center conductor 3. Furthermore, an electric field shield is sometimes inserted.

When a partial discharge is generated in GIS, an electromagnetic wave is generated by the partial discharge and propagated in the tank. The system for determining such a partial discharge is configured by focusing attention on a TE11 mode signal as a mode of the electromagnetic wave propagating along the coaxial tank structure as in Reference Examples.

In order to determine a partial discharge by taking advantage of characteristics of the TE11 mode, an intensity distribution of electromagnetic waves in an outer circumferential direction of the tank 1, that is, an intensity distribution of outer circumferential electromagnetic waves in the insulating spacer 2 needs to be known at measurement.

In Fig. 1, an electromagnetic wave detector 4 is movable along the outer circumferential direction of the insulating spacer 2 as in Reference Example 1, determination of partial discharge using the TE11 mode can be made by inputting an output of the electromagnetic wave detector 4 along the outer circumferential direction of the insulating spacer 2 to a determining section 7. In addition, reference numeral 5 denotes a moving device, 6 denotes a displacement angle detector, and 12 denotes a guiding rail.

The system for determining partial discharge has the electromagnetic wave detector 4 for detecting an electromagnetic wave signal, which propagates in the tank 1, at a plurality of outer circumferential positions of the insulating spacer 2; and a TE11 envelope detector 8 for extracting a signal of a frequency band in which the TE11 mode propagates but a TE21 mode does not propagate by utilizing a cutoff frequency.

Further, the system for determining partial discharge has an intensity detector for detecting an intensity distribution of outer circumferential electromagnetic waves in the tank 1 from signal strength extracted with the TE11 envelope detector 8 and outer circumferential position information $\theta$ of the electromagnetic wave detector 4. The intensity detector can be configured by a pattern recognition device 22 as described in Fig. 16 and Fig. 17. A patterned output of the pattern recognition device 22 can be displayed in a detection pattern indicator 23 as a circular intensity distribution view such as shown in Fig. 15(c) of Fig. 15, and Fig. 18(b) and Fig. 18(c) of Fig. 18.

Outline and inside structure information of the gas-insulated equipment to be observed for determination is input to a structure information output unit 24 and stored therein. Information such as a straight pipe tank, an L shaped tank, and a T shaped tank of the gas-insulated equipment to be observed for determination is included as the outline structure information to be stored in the a structure information output unit 24; and positions of the insulating spacers in each tank may be incorporated.

The presence or absence of the post spacer and the electric field shield in the gas-insulated equipment to be observed for determination, mounting positions thereof, mounting directions, shapes, and the like are included as the inside structure information to be stored in the structure information output unit 24. An assumption pattern indicator 25 obtains intensity distribution information detected at one of the insulating spacers in the gas-insulated equipment to be observed for determination from the pattern recognition device 22, and obtains the outline and inside structure information from the structure information output unit 24.

From such information, an intensity distribution assumed at the other insulating spacer when a partial discharge occurs in the gas-insulated equipment to be observed for determination is patterned to display on the assumption pattern indicator 25, Therefore, the intensity distribution assumed at the other insulating spacer from such information when a partial discharge occurs in the gas-insulated equipment to be observed for determination is recorded in the assumption pattern indicator 25 as a case example.

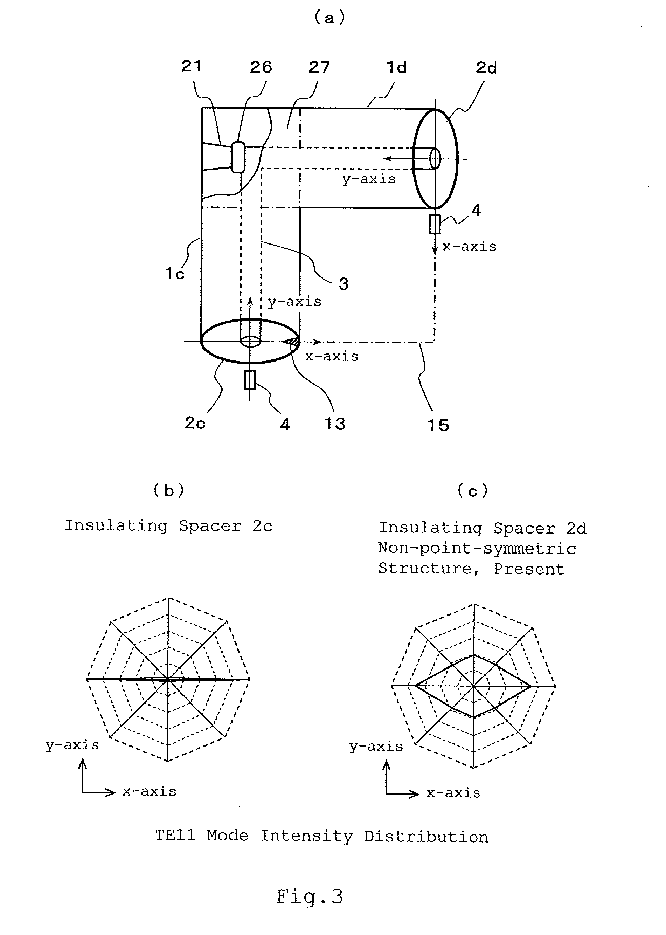

For example, an intensity distribution at an insulating spacer 2d generated when a partial discharge occurs, the intensity distribution being assumed from the outline and inside structure information and the intensity distribution information at an insulating spacer 2c which are to be described later in Fig. 3, is recorded. In addition, display on the assumption pattern indicator 25 can be made as a circular intensity distribution view such as Fig. 15(c) of Fig. 15 and Fig. 18(b) and Fig. 18(c) of Fig. 18. In addition, furthermore, only the outline and inside structure information of the structure information output unit 24 can be displayed on the assumption pattern indicator 25.

A determining device 11 compares the output patterned by the pattern recognition device 22 with the patterned output assumed by the assumption pattern indicator 25 on the basis of the intensity distribution actually detected at the other insulating spacer; and the presence or absence of the partial discharge generated in the gas-insulated equipment to be observed for determination is determined by a matching degree.

The case where the thus configured system for determining partial discharge is applied to measurement of the L shaped tank will be described. Referring to Reference Example 2 and Fig. 18, the insulating spacers 2c and 2d are respectively disposed behind and in front of the L shaped bent part with respect to the L shaped tanks 1c and 1d. In order to specify the direction in the Figure, a plane including axis lines of the tanks 1c and 1d is defined as a reference plane 15, The case where the partial discharge source 13 is located on the tank 1c side at the position which passes through the axis center in the direction (x-axis direction) parallel to the reference plane 15 will be described.

When the electromagnetic wave propagates in the tank, in the case of passing through the L shaped bent part, conversion of the electromagnetic wave mode occurs at the bent part, and the shape of circumferential distribution of the signal is lost as described in Reference Example 2. In this case, as shown in Fig. 18, the intensity distribution of the TE11 mode having a peak value in the direction (x-axis direction) substantially parallel to the reference plane 15 in the insulating spacer 2c like Fig. 18(b) of Fig. 18 is confirmed. Then, in the insulating spacer 2d after passing the L shaped bent part, the intensity distribution appears in the all circumferential directions, as shown in Fig. 18(c) of Fig. 18, unlike the distribution in 2c.

However, with respect to the distribution of the TE11 mode having a peak value in the direction (x-axis direction) substantially parallel to the reference plane 15, as only one post spacer 21 shown in Fig. 3(a) of Fig. 3, in the case where a structure is connected to the center conductor at the bent part in parallel to the reference plane and the structure is not a point-symmetric configuration centered on an axial point of the center conductor, it has been noted that there appears a mode change different from Fig. 18(c) of Fig. 18 as shown in Fig. 3(c) of Fig. 3.
In addition, Fig. 3(a) of Fig. 3 shows an occurrence position of a partial discharge in an L shaped tank when there is the post spacer; Fig. 3(b) shows an intensity distribution of electromagnetic waves at one insulating spacer; and Fig. 3(c) shows an intensity distribution of electromagnetic waves at the other insulating spacer.
Reference numeral 26 in Fig. 3(a) denotes an electric field relaxation shield for the post spacer 21. The post spacer 21 attached with the electric field relaxation shield is not a point-symmetric configuration centered on an axial point of the center conductor. There is a case where a hand hole is provided at the bent part of the L shaped tank, and the post spacer 21 is mounted at the bent part of the L shaped tank through the hand hole to support the center conductor. In addition, the bent part of the L shaped tank is a portion where an extending tank I c and a tank 1d are intersected, and the bent part is a portion 27 surrounded by a dashed line shown in Fig. 3.

When a signal having a peak value in the direction (x-axis direction) substantially parallel to the reference plane 15 comes into the L shaped bent part, a signal transmission path deviates toward only one side because the structure is not a point-symmetry centered on an axial point with respect to a direction having its signal distribution, but the structure exists on only one side. Therefore, it is finally considered to be an influence on a distribution in the insulating spacer 2d, and a distribution having a peak value in a direction substantially parallel to the reference plane 15 is prominently observed.

As described, in the case where the structure is connected to the center conductor at the bent part in parallel to the above reference plane so as to overlap with the signal intensity distribution, and the above structure is not a point-symmetric configuration centered on an axial point of the center conductor; and when an intensity distribution having two peak values in a direction substantially parallel to the above reference plane at one insulating spacer is confirmed, and an intensity distribution having two peak values in a direction substantially parallel to the above reference plane at the other insulating spacer is confirmed; it can be determined that a partial discharge occurs in the L shaped tank.

As a specific determining method, when the inside structure information can be obtained, and when a non-point-symmetric structure centered on an axial point of the center conductor is not located at the bent part 27; and when an intensity distribution having two peak values in a direction substantially parallel to the reference plane (x-axis direction or horizontal direction) at one insulating spacer is confirmed, and an intensity distribution having substantially the same level in the entire circumference at the other insulating spacer is confirmed; it is determined that a partial discharge occurs in the L shaped tank.
On the other hand, when the inside structure information can be obtained, and when the structure is connected to the center conductor of the bent part 27 in parallel to the reference plane, and the above structure is not a point-symmetric configuration centered on an axial point of the center conductor; and when an intensity distribution having two peak values in a direction substantially parallel to the reference plane (x-axis direction or horizontal direction) at one insulating spacer is confirmed, and an intensity distribution having two peak values in a direction substantially parallel to the reference plane at the other insulating spacer is confirmed; it is determined that a partial discharge occurs in the L shaped tank.

In addition, when the inside structure information cannot be obtained (when the inside structure information is unknown), and when an intensity distribution having two peak values in a direction substantially parallel to the reference plane at one insulating spacer is confirmed, and an intensity distribution having two peak values in a direction substantially parallel to the reference plane at the other insulating spacer is confirmed, or an intensity distribution having substantially the same level in the entire circumference at the other insulating spacer is confirmed; it is determined that a partial discharge occurs in the L shaped tank.

The description will be made by applying the above specific determining method to the system for determining partial discharge shown in Fig. 1. "A non-point-symmetric structure centered on an axial point of a center conductor is not located at a bent part in an L shaped tank" is input and stored in the structure information output unit 24 as the outline and inside structure information. The information in the structure information output unit 24 can also be displayed on the assumption pattern indicator 25. In this case, measurement is made at one insulating spacer 2c (Fig. 18(a)), and the intensity distribution having two peak values substantially parallel to the reference plane is confirmed (Fig. 18(b)).
This confirmation information is displayed on the detection pattern indicator 23 as an output of the pattern recognition device 22. The assumption pattern indicator 25 displays the intensity distribution assumed at the other insulating spacer 2d when a partial discharge occurs as an assumption pattern (pattern shown in Fig. 18(c)) by selecting from the recorded case example, from the information of the structure information output unit 24 and the intensity distribution information of the pattern recognition device 22.

Subsequently, measurement is actually made at the other insulating spacer 2d, and the intensity distribution is obtained with the pattern recognition device 22. This intensity distribution can be displayed by the detection pattern indicator 23. The patterned output of the pattern recognition device 22 is input to the determining device 11 to compare with the former assumption pattern of the assumption pattern indicator 25, and it can be determined whether or not a partial discharge occurs in the L shaped tank 1 by a matching degree between both patterns.

In addition, even when there is no such determining device 11, a measurer can assume the intensity distribution assumed at the other insulating spacer 2d when a partial discharge occurs, from the intensity distribution information detected at one insulating spacer 2c and the inside structure information of the structure information output unit 24; and therefore, it can be determined whether or not a partial discharge exists in the gas-insulated equipment by comparing the assumed intensity distribution with the intensity distribution actually detected at the other insulating spacer 2d by the measurer.

In addition, furthermore, if there is the inside structure information, the measurer can know the structure information of the structure information output unit 24 by appearance without the outline structure information. The outline structure information is required when the determining device is automated.

Furthermore, even measurement sequence of the insulating spacer 2c (pattern shown in Fig. 18(b)) and the insulating spacer 2d (pattern shown in Fig. 18(c)) is reversed, determination can be made in the same way.

Next, "a structure is connected to a center conductor at a bent part in an L shaped tank in parallel to a reference plane, and there is the structure which is not a point-symmetry centered on an axial point of the center conductor" is input and stored in the structure information output unit 24 as the outline and inside structure information. In this case, measurement is made at one insulating spacer 2c, and the intensity distribution having two peak values substantially parallel to the reference plane is confirmed (Fig. 3(b)).

This confirmation information is displayed on the detection pattern indicator 23 as an output of the pattern recognition device 22. The assumption pattern indicator 25 displays the intensity distribution assumed at the other insulating spacer 2d when a partial discharge occurs as an assumption pattern (pattern shown in Fig. 3(c)), from the information of the structure information output unit 24 and the intensity distribution information of the pattern recognition device 22.

Subsequently, measurement is actually made at the other insulating spacer 2d, and the intensity distribution is obtained with the pattern recognition device 22. This intensity distribution can be displayed by the detection pattern indicator 23. The patterned output of the pattern recognition device 22 is input to the determining device 11 to compare with the former assumption pattern of the assumption pattern indicator 25, and it can be determined whether or not a partial discharge occurs in the L shaped tank 1 by a matching degree between both patterns.

In addition, even in this case, when there is no such determining device 11, the measurer can assume the intensity distribution assumed at the other insulating spacer 2d when a partial discharge occurs, from the intensity distribution information detected at one insulating spacer 2c and the inside structure information of the structure information output unit 24; and therefore, it can be determined whether or not a partial discharge exists in the gas-insulated equipment by comparing the assumed intensity distribution with the intensity distribution actually detected at the other insulating spacer 2d by the measurer.

In addition, there is a case when the inside structure information of the tank is unknown. Even in this case, measurement is made at one insulating spacer 2c, and the intensity distribution having two peak values substantially parallel to the reference plane (horizontal direction) is confirmed (Fig. 3(b)). This confirmation information is displayed on the detection pattern indicator 23 as an output of the pattern recognition device 22.

The assumption pattern indicator 25 displays two intensity distributions assumed at the other insulating spacer 2d when a partial discharge occurs as assumption patterns (patterns shown in Fig. 3(c) and Fig. 18(c)), from only the intensity distribution information of the pattern recognition device 22 because the information from the structure information output unit 24 is unknown.

Subsequently, measurement is actually made at the other insulating spacer 2d, and the intensity distribution is obtained with the pattern recognition device 22. This intensity distribution can be displayed by the detection pattern indicator 23. The patterned output of the pattern recognition device 22 is input to the determining device 11 to compare with the former two assumption patterns of the assumption pattern indicator 25 respectively, and it can be determined whether or not a partial discharge occurs in the L shaped tank 1 by any of matching degrees.

In addition, even in this case, also when there is no such determining device 11, the measurer can assume two intensity distributions assumed at the other insulating spacer 2d when a partial discharge occurs, from the intensity distribution information detected at one insulating spacer 2c; and therefore, it can be determined whether or not partial discharge exists in the gas-insulated equipment by comparing any of the assumed two intensity distributions with the intensity distribution actually detected at the other insulating spacer 2d by the measurer.

Embodiment 2

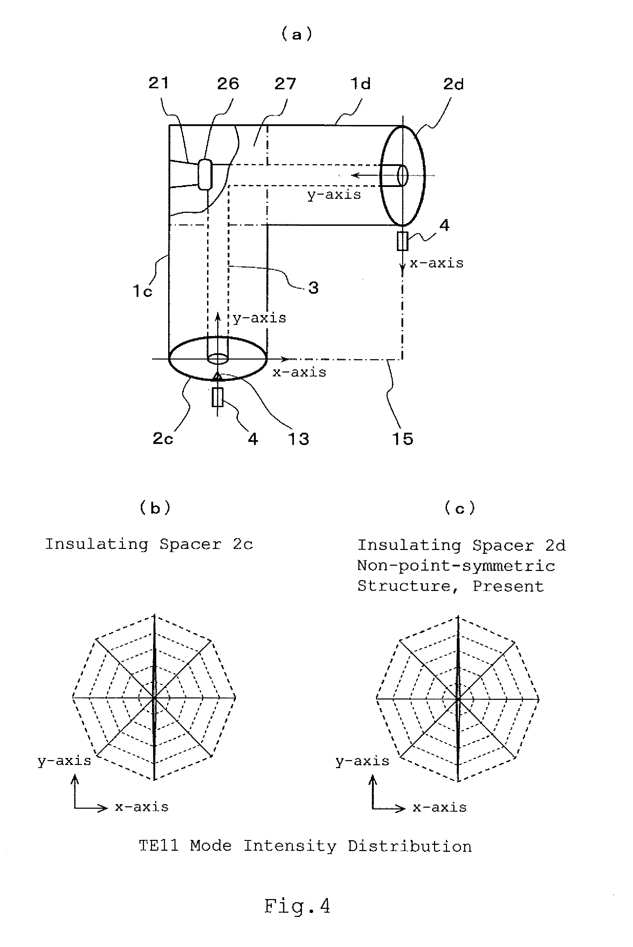

Embodiment 2 is different from Embodiment 1 in a position of providing a partial discharge source 13, and is an example when the partial discharge source 13 is generated on a tank 1c side in a direction (y-axis direction) perpendicular to a reference plane 15. In an L shaped tank 1, a structure (post spacer) 21 is connected to a center conductor at a bent part 27 in parallel to the reference plane as in Fig. 3, and the structure is not a point-symmetric configuration centered on an axial point of the center conductor. Fig. 4(a) of Fig. 4 shows an occurrence position of the partial discharge in the L shaped tank; Fig. 4(b) shows an intensity distribution of electromagnetic waves at one insulating spacer; and Fig. 4(c) shows an intensity distribution of electromagnetic waves at the other insulating spacer.

When there is no such post spacer 21, as shown in Fig. 19 of Reference Example 2, an electromagnetic wave of a TE11 mode due to partial discharge observed at an insulating spacer 2c has a peak value in a direction (y-axis direction) perpendicular to the reference plane 15 as shown in Fig. 19(b); and even a signal observed at an insulating spacer 2d after passing the L shaped bent part, a signal distribution having a peak value in a direction perpendicular to the reference plane 15 is confirmed as shown in Fig. 19(c).

On the other hand, as shown in Fig. 4, verification has been made in the case where the post spacer 21 is connected to the center conductor at the bent part 27 in parallel to the reference plane, and the post spacer 21 is not a point-symmetric configuration centered on an axial point of the center conductor. According to the verification, electromagnetic waves due to partial discharge observed at an insulating spacer 2c have a peak value in a direction (y-axis direction) perpendicular to the reference plane 15 as shown in Fig. 4(b); and even a signal observed at an insulating spacer 2d after passing the L shaped bent part, a signal distribution having a peak value in a direction perpendicular to the reference plane 15 is confirmed as shown in Fig. 4(c).

As a result, in a determining concept simply focused on the peak, it may be said that Fig. 19(b) and Fig. 19(c) and Fig. 4(b) and Fig. 4(c) have substantially the same distribution.

Embodiment 3

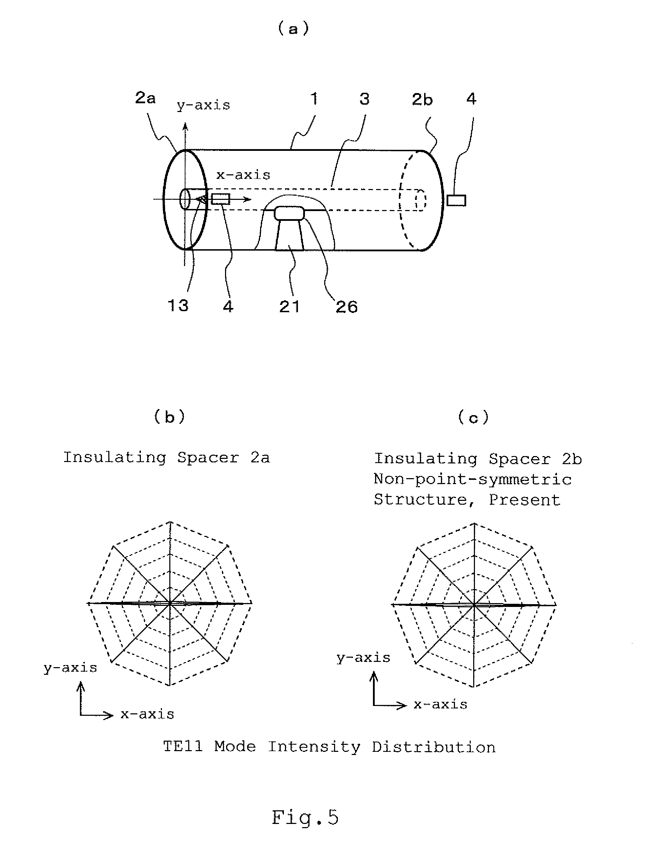

Verification has been made in the case where a post spacer is mounted in a straight pipe tank and a T shaped tank other than an L shaped tank. Embodiment 3 is an example where the post spacer is mounted in the straight pipe tank. As shown in Fig. 5, a post spacer 21 for supporting a center conductor is mounted on the bottom surface side. The post spacer (structure) 21 is not a point-symmetric configuration centered on an axial point of the center conductor. Fig. 5 (a) of Fig. 5 shows an occurrence position of a partial discharge in the straight pipe tank; Fig. 5(b) shows an intensity distribution of electromagnetic waves at one insulating spacer; and Fig. 5(c) shows an intensity distribution of electromagnetic waves at the other insulating spacer.

As described in Fig. 15 of Reference Example 1, when there is no such post spacer 21, and when a partial discharge occurs in a horizontal direction (x-axis direction), two peaks of electromagnetic waves are observed in the horizontal direction at both insulating spacers 2a and 2b. Even when the post spacer 21 is mounted as shown in Fig. 5, and when a partial discharge occurs in a horizontal direction (x-axis direction), two peaks are observed in the horizontal direction at both insulating spacers 2a and 2b irrespective of the presence of a non-point-symmetric structure with respect to an axis of the center conductor. This is the same even an axial position of the center conductor at the post spacer 21 is changed. Therefore, its tendency is not changed irrespective of the presence or absence of the structure, and the same determining algorithm is realized.

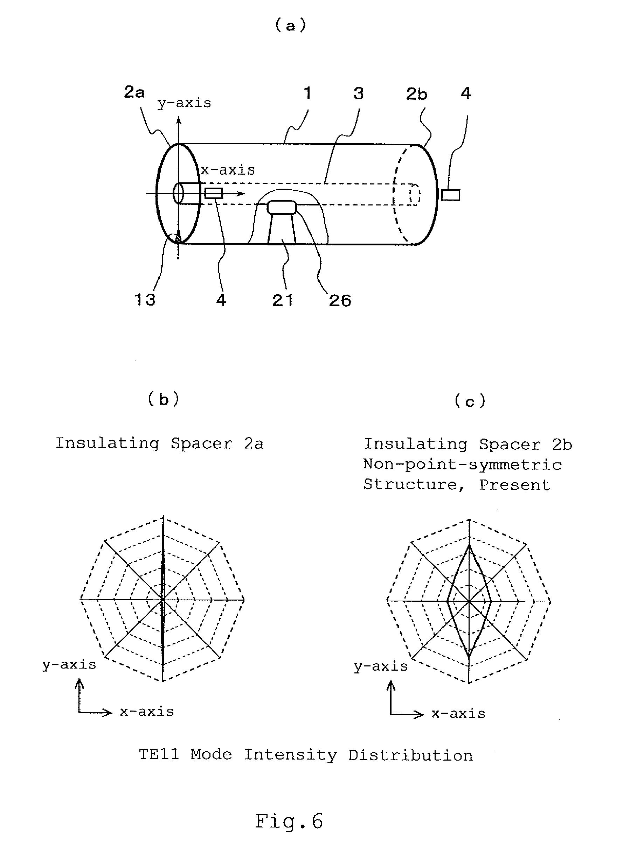

On the other hand, when a partial discharge occurs in a vertical direction (y-axis direction), and when there exists a non-point-symmetric structure (post spacer) 21 with respect to a center conductor axis on the bottom surface side, two peaks are observed in the vertical direction in an intensity distribution of electromagnetic waves measured at the insulating spacer 2a as shown in Fig. 6(b). As shown in Fig. 6(c), a pattern shape of the electromagnetic waves measured at the insulating spacer 2b is lost, and components other than the vertical direction increase; however, it is not largely changed in that two peaks are observed in the vertical direction.

This is the same even the axial position of the center conductor at the structure 21 is changed. Therefore, it is possible to determine the presence or absence of the partial discharge with high accuracy by knowing these phenomena. In addition, Fig. 6(a) of Fig. 6 shows an occurrence position of a partial discharge in the straight pipe tank; Fig. 6(b) shows an intensity distribution of electromagnetic waves at one insulating spacer; and Fig. 6(c) shows an intensity distribution of electromagnetic waves at the other insulating spacer.

Embodiment 4

Embodiment 4 is an example in which a post spacer is mounted in a T shaped tank. The T shaped tank has a straight pipe part and a branch pipe part which is branched in a T shape in the middle of the straight pipe part; and the above tanks extending in three directions from a branched part are respectively provided with insulating spacers. When a plane including axis lines (an axis line of the straight pipe part and an axis line of the branch pipe part) of the T shaped tank is defined as a reference plane, a structure (post spacer) is connected to a center conductor at the branched part in parallel to the reference plane, and the above structure is not a point-symmetric configuration centered on an axial point of the center conductor.

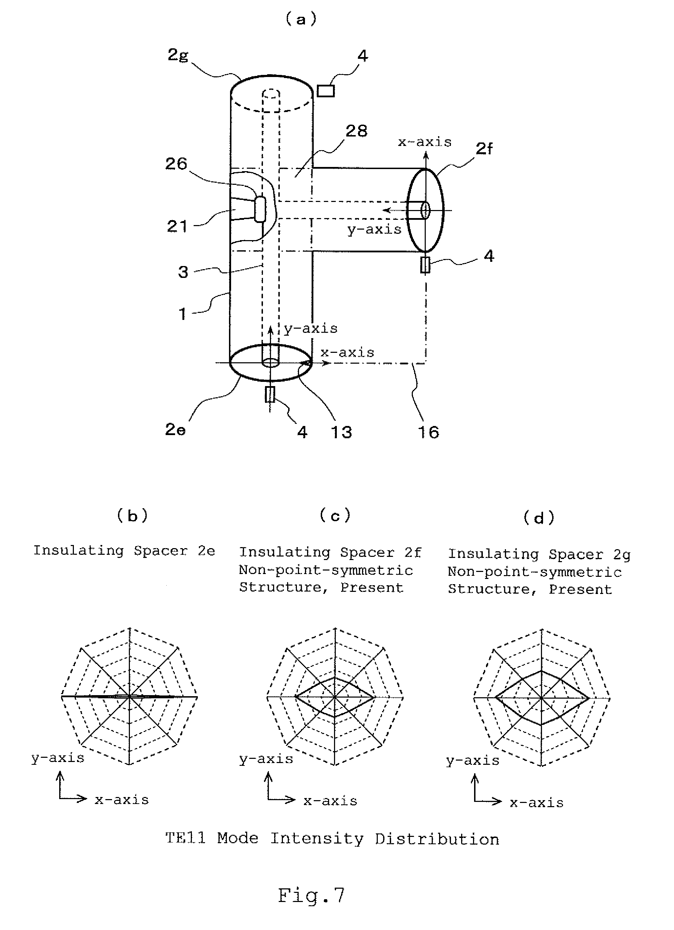

There is a case where a hand hole is provided at the branched part of the T shaped tank, and the post spacer is mounted at the branched part of the T shaped tank through the hand hole to support the center conductor. In addition, the branched part of the T shaped tank is a portion where the extending straight pipe tank and the branch pipe tank are intersected, and the branched part is a portion 28 surrounded by a dashed line shown in Fig. 7.

Fig. 7 shows a case where there is a partial discharge source 13 located on one side of the straight pipe part of the T shaped tank in a direction (x-axis direction or horizontal direction) passing through the axis center and parallel to the reference plane 16. Fig. 7(a) of Fig. 7 shows an occurrence position of a partial discharge in the T shaped tank; Fig. 7(b) shows an intensity distribution of electromagnetic waves at an insulating spacer 2e; Fig. 7(c) shows an intensity distribution of electromagnetic waves at an insulating spacer 2f; and Fig. 7(d) shows an intensity distribution of electromagnetic waves at an insulating spacer 2g.

When there is no such post spacer 21, as shown in Fig. 21 of Reference Example 3, two peaks of electromagnetic waves are observed in substantially parallel to the reference plane at the insulating spacer 2e; and intensity distributions having substantially the same level in the entire circumference are observed at both insulating spacers 2f and 2g.

On the other hand, when the structure (post spacer) 21 is connected to the center conductor at the branched part 28 in parallel to the reference plane, and the structure is not a point-symmetric configuration centered on an axial point of the center conductor, an intensity distribution having two peak values in a horizontal direction at the insulating spacer 2e is confirmed.

Intensity distributions broadening in a vertical direction (y-axis direction) and having two peak values in a horizontal direction are confirmed at the insulating spacers 2f and 2g. In addition, in this case, "a structure is connected to a center conductor at a branched part in a T-shaped tank in parallel to a reference plane, and the structure is not a point-symmetric configuration centered on an axial point of the center conductor" is input to a structure information output unit 24 as outline and inside structure information.

As described, in the T shaped tank, when the outline and inside structure information of gas-insulated equipment obtained from the structure information output unit is "a structure is connected to a center conductor at a branched part in a T-shaped tank in parallel to a reference plane, and the structure is not a point-symmetric configuration centered on an axial point of the center conductor, it is determined that a partial discharge occurs in the tank in the case where an intensity distribution having two peak values in a direction substantially parallel to the reference plane is confirmed at all the three insulating spacers.

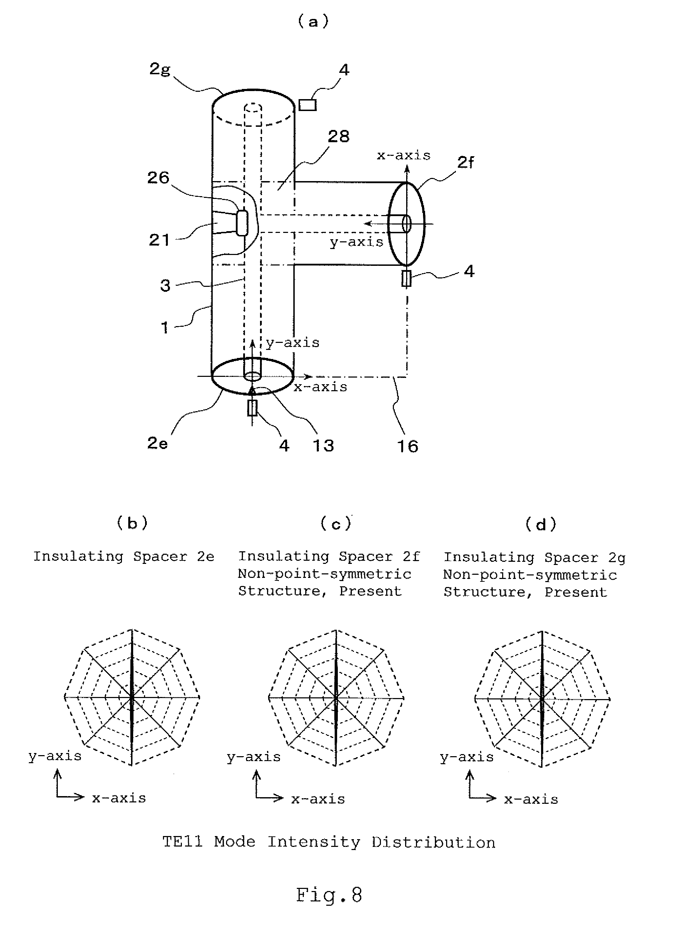

Fig. 8 shows a case which is different from Fig. 7 in a position of providing the partial discharge source and there is the partial discharge source 13 located on one side of the straight pipe part of the T shaped tank in a direction (y-axis direction) perpendicular to the reference plane. Fig. 8(a) of Fig. 8 shows an occurrence position of a partial discharge in the T shaped tank; Fig. 8(b) shows an intensity distribution of electromagnetic waves at an insulating spacer 2e; Fig. 8(c) shows an intensity distribution of electromagnetic waves at an insulating spacer 2f; and Fig. 8(d) shows an intensity distribution of electromagnetic waves at an insulating spacer 2g.

When there is no such post spacer 21, as shown in Fig. 23 of Reference Example 3, two peaks of electromagnetic waves are observed in the vertical direction at all the insulating spacers 2e, 2f, and 2g.

On the other hand, even in the case where the structure (post spacer) 21 is connected to the center conductor at the branched part 28 in the T shaped tank in parallel to the reference plane, and the structure is not a point-symmetric configuration centered on an axial point of the center conductor, two peaks of electromagnetic waves are observed in the vertical direction at all the insulating spacers 2e, 2f, and 2g as shown in Fig. 8(b), Fig. 8(c), and Fig. 8(d). Therefore, its tendency is not changed irrespective of the presence or absence of the structure, and the same determining algorithm is realized.

Embodiment 5

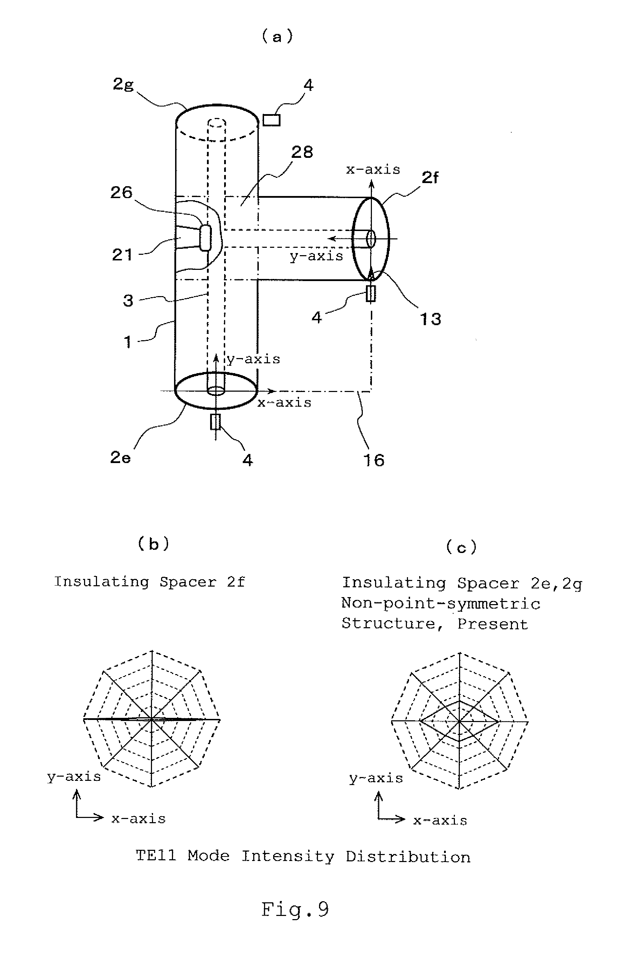

Embodiment 5 is different from Embodiment 4 in a position of providing a partial discharge source 13, and is an example when the partial discharge source 13 is generated on a branch pipe part side. A structure (post spacer) is connected to a center conductor at a branched part 28 in a T shaped tank in parallel to a reference plane, and the structure is not a point-symmetric configuration centered on an axial point of the center conductor as in Embodiment 4. Fig. 9 shows a case where the partial discharge source 13 is generated in a direction (x-axis direction) passing through the axis center and substantially parallel to the reference plane 16. Fig. 9(a) of Fig. 9 shows an occurrence position of a partial discharge in the T shaped tank; Fig. 9(b) shows an intensity distribution of electromagnetic waves at an insulating spacer 2f; and Fig. 9(c) shows an intensity distribution of electromagnetic waves at insulating spacers 2e and 2g.

When there is no such post spacer 21, as shown in Fig. 22 of Reference Example 3, two peaks of electromagnetic waves are observed in substantially parallel to the reference plane at the insulating spacer 2f; and intensity distributions having substantially the same level in the entire circumference are observed at both insulating spacers 2e and 2g.

On the other hand, when the structure (post spacer) 21 is connected to the center conductor at the branched part 28 in parallel to the reference plane, and the structure is not a point-symmetric configuration centered on an axial point of the center conductor, an intensity distribution having two peak values in a direction substantially parallel to the reference plane at the insulating spacer 2f is confirmed.

Intensity distributions broadening in a direction (y-axis direction) perpendicular to the reference plane and having two peak values in a direction parallel to the reference plane are confirmed at the insulating spacers 2e and 2g. In addition, in this case, "a structure is connected to a center conductor of a branched part in a T-shaped tank in parallel to a reference plane, and the structure is not a point-symmetric configuration centered on an axial point of the center conductor" is input to a structure information output unit 24 as outline and inside structure information.

As described, in the T shaped tank, when the outline and inside structure information obtained from the structure information output unit is "a structure is connected to a center conductor of a branched part in a T-shaped tank in parallel to a reference plane, and the structure is not a point-symmetric configuration centered on an axial point of the center conductor," it is determined that a partial discharge occurs in the tank in the case where an intensity distribution having two peak values in a direction substantially parallel to the reference plane is confirmed at all the three insulating spacers.

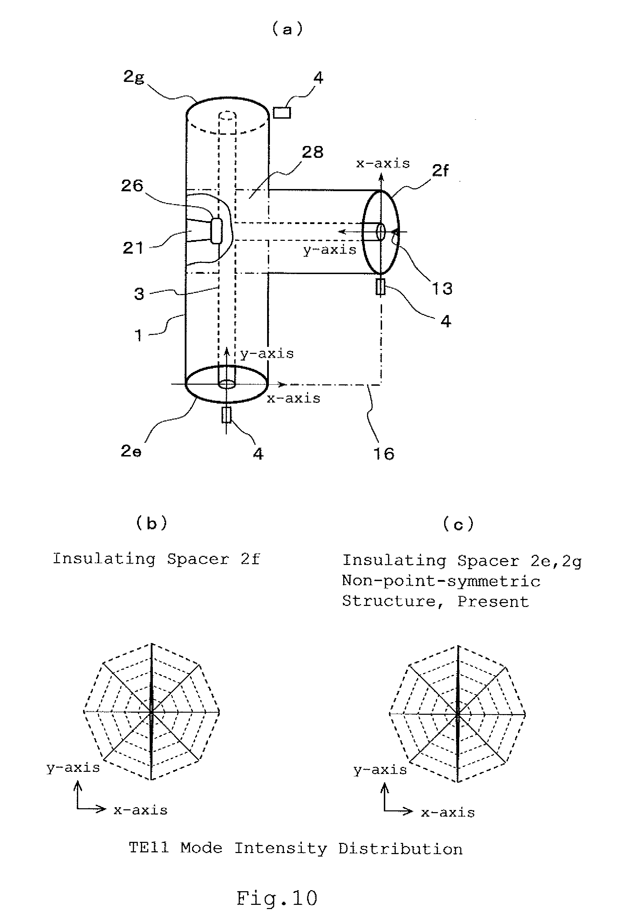

Fig. 10 shows a case which is different from Fig. 9 in a position of providing the partial discharge source and the partial discharge source 13 is generated on the branch pipe part side of the T shaped tank in a direction (y-axis direction) substantially perpendicular to the reference plane 16. Fig. 10(a) of Fig. 10 shows an occurrence position of a partial discharge in the T shaped tank; Fig. 10(b) shows an intensity distribution of electromagnetic waves at the insulating spacer 2f; and Fig. 10(c) shows intensity distributions of electromagnetic waves at the insulating spacers 2e and 2g.

When there is no such post spacer 21, as shown in Fig. 24 of Reference Example 3, two peaks of electromagnetic waves are observed in the vertical direction at all the insulating spacers 2f, 2e, and 2g.
On the other hand, even in the case where the structure (post spacer) 21 is connected to the center conductor at the branched part 28 in the T shaped tank in parallel to the reference plane, and the structure is not a point-symmetric configuration centered on an axial point of the center conductor, two peaks of electromagnetic waves are observed in the vertical direction at all the insulating spacers 2f, 2e, and 2g as shown in Figs. 10(b) and Fig. 10(c). Therefore, its tendency is not changed irrespective of the presence or absence of the structure, and the same determining algorithm is realized.

As described above, the post spacer attached with the electric field relaxation shield mounted in gas-insulated equipment is one which is generally used in the gas-insulated equipment. It is possible to increase in accuracy of determination at the time when a partial discharge occurs by knowing an intensity distribution of electromagnetic waves at each insulating spacer assumed during occurring of the partial discharge when the post spacer is mounted in the gas-insulated equipment as a case example, or by storing the same in an assumption pattern indicator.
Further, it is possible to increase in accuracy of determination at the time when a partial discharge occurs by accumulating case examples of structure information and intensity distributions at respective insulating spacers during occurring of the partial discharge with respect to other structures mounted in the gas-insulated equipment, and by knowing or recording the structure information and the intensity distributions at respective insulating spacers during occurring of the partial discharge with respect to such accumulated case examples.
While the presently preferred embodiments of the present invention have been shown and described. It is to be understood that these disclosures are for the purpose of illustration and that various changes and modifications may be made without departing from the scope of the invention as set forth in the appended claims.

## Claims

1. A method of determining partial discharge, wherein as gas-insulated equipment, which is configured so that a cylindrical metal tank sealed with insulating gas is partitioned by insulating spacers and a center conductor is supported by the insulating spacers, is to be observed for determining the presence or absence of a partial discharge generated in the metal tank, the method including the steps of: detecting an electromagnetic wave signal at a plurality of outer circumferential positions of the insulating spacer with an electromagnetic wave detector, the electromagnetic wave signal propagating in the metal tank; extracting a signal of a frequency band in which a TE11 mode propagates but a TE21 mode does not propagate by utilizing a cutoff frequency from the detected electromagnetic wave signal, with a TE11 envelope detector;

and determining a partial discharge by detecting an intensity distribution of outer circumferential electromagnetic waves in the metal tank with an intensity detector from the intensity of the extracted signal with the TE11 envelope detector and the outer circumferential position information of the electromagnetic wave detector, the method comprising:

- a structure information output unit which outputs inside structure information of the gas-insulated equipment; and
- the step of determining the presence or absence of a partial discharge from the intensity distribution of the outer circumferential electromagnetic waves in the metal tank detected with the intensity detector and the inside structure information of the structure information output unit.

**2.** The method of determining partial discharge according to claim 1, further comprising:

- a structure information output unit which outputs outline and inside structure information of the gas-insulated equipment; and
- the step of determining the presence or absence of a partial discharge from the intensity distribution of the outer circumferential electromagnetic waves in the metal tank detected with the intensity

detector and the outline and inside structure information of the gas-insulated equipment.

**3.** The method of determining partial discharge according to claim 2, wherein the metal tank has an L shaped bent part; and the metal tanks extending in two directions from the bent part are respectively provided with the insulating spacers, further comprising the step of determining that a partial discharge occurs in the L shaped metal tank when the outline and inside structure information of the gas-insulated equipment obtained from the structure information output unit defines a plane including axis lines of the L shaped metal tank as a reference plane and when a structure is connected to the center conductor at the bent part in parallel to the reference plane and the structure is not a point-symmetric configuration centered on an axial point of the center conductor and in the case where an intensity distribution having two peak values in a direction substantially parallel to the reference plane at one insulating spacer is confirmed and an intensity distribution having two peak values in a direction substantially parallel to the reference plane at the other insulating spacer is confirmed.

**4.** The method of determining partial discharge according to claim 2, wherein the metal tank has an L shaped bent part; and the metal tanks extending in two directions from the bent part are respectively provided with the insulating spacers, further comprising the step of determining that a partial discharge occurs in the L shaped metal tank when the outline and inside structure information of the gas-insulated equipment obtained from the structure information output unit is that a structure is connected to the center conductor at the bent part and the structure is a point-symmetric configuration centered on an axial point of the center conductor and in the case where, when a plane including axis lines of the L shaped metal tank is defined as a reference plane, an intensity distribution having two peak values in a direction substantially parallel to the reference plane at one insulating spacer is confirmed and an intensity distribution having substantially the same level in the entire circumference at the other insulating spacer is confirmed.

**5.** The method of determining partial discharge according to claim 2, wherein the metal tank has a straight pipe part and a branch pipe part which is branched in a T shape in the middle of the straight pipe part; and the metal tanks extending in three directions from the branched part are respectively provided with the insulating spacers, further comprising the step of determining that a partial discharge occurs in the metal tank when the outline and inside structure information of the gas-insulated equipment obtained from the structure information output unit defines a plane including axis lines of the T shaped metal tank as a reference plane and when a structure is connected to the center conductor at the branched part in parallel to the reference plane and the structure is not a point-symmetric configuration centered on an axial point of the center conductor and in the case where an intensity distribution having two peak values in a direction substantially parallel to the reference plane at all the three insulating spacers is confirmed.

**6.** A method of determining partial discharge, wherein as gas-insulated equipment, which is configured so that a cylindrical metal tank sealed with insulating gas is partitioned by insulating spacers and a center conductor is supported by the insulating spacers, is to be observed for determining the presence or absence of a partial discharge generated in the metal tank, the method including the steps of: detecting an electromagnetic wave signal at a plurality of outer circumferential positions of the insulating spacer with an electromagnetic wave detector, the electromagnetic wave signal propagating in the metal tank; extracting a signal of a frequency band in which a TE11 mode propagates but a TE21 mode does not propagate by utilizing a cutoff frequency from the detected electromagnetic wave signal, with a TE11 envelope detector; and determining a partial discharge by detecting an intensity distribution of outer circumferential electromagnetic waves in the metal tank with an intensity detector from the intensity of the extracted signal with the TE11 envelope detector and the outer circumferential position information of the electromagnetic wave detector,
wherein the method is such that the presence or absence of a partial discharge is determined on the basis of the intensity distribution of the outer circumferential electromagnetic waves in the metal tank detected with the intensity detector; and
the metal tank has an L shaped bent part, and the metal tanks extending in two directions from the bent part are respectively provided with the insulating spacers,

the method comprising the step of determining that a partial discharge occurs in the L shaped metal tank when inside structure information of the gas-insulated equipment is unknown and in the case where, when a plane including axis lines of the L shaped metal tank is defined as a reference plane, an intensity distribution having two peak values in a direction substantially parallel to the reference plane at one insulating spacer is confirmed and an intensity distribution having two peak values in a direction substantially parallel to the reference plane at the other insulating spacer is confirmed or an intensity distribution having substantially the same level in the entire circumference at the other insulating spacer is confirmed.

7. A system for determining partial discharge, wherein as gas-insulated equipment, which is configured so that a cylindrical metal tank sealed with insulating gas is partitioned by the insulating spacers and a center conductor is supported by the insulating spacers, is to be observed for determining the presence or absence of a partial discharge generated in the metal tank, the system including: an electromagnetic wave detector for detecting an electromagnetic wave signal at a plurality of outer circumferential positions of the insulating spacer, the electromagnetic wave signal propagating in the metal tank; a TE11 envelope detector for extracting a signal of a frequency band in which a TE11 mode propagates but a TE21 mode does not propagate by utilizing a cutoff frequency from the detected electromagnetic wave signal; and an intensity detector for detecting an intensity distribution of outer circumferential electromagnetic waves in the metal tank from the intensity of the extracted signal with the TE11 envelope detector and the outer circumferential position information of the electromagnetic wave detector, the system comprising:

a structure information output unit which outputs inside structure information of the gas-insulated equipment.

8. The system for determining partial discharge according to claim 7, wherein the structure information output unit outputs outline and inside structure information of the gas-insulated equipment.

Radius of Metal Tank: a
Radius of Center
Conductor: b

4: Electromagnetic Wave Detector
5: Moving Device
6: Displacement Angle Detector
7: Determining Section

Fig.1

4: Electromagnetic Wave Detector
5: Moving Device
6: Displacement Angle Detector

Fig.2

(a)

21   26   27   1d   2d

y-axis

4

x-axis

1c

3

y-axis

x-axis

2c   4   13   15

(b)

Insulating Spacer 2c

(c)

Insulating Spacer 2d
Non-point-symmetric
Structure, Present

y-axis

x-axis

y-axis

x-axis

TE11 Mode Intensity Distribution

Fig.3

( a )

( b )

Insulating Spacer 2c

( c )

Insulating Spacer 2d
Non-point-symmetric
Structure, Present

TE11 Mode Intensity Distribution

Fig.4

( a )

( b )                                    ( c )

Insulating Spacer 2a            Insulating Spacer 2b
                                Non-point-symmetric
                                Structure, Present

TE11 Mode Intensity Distribution

Fig.5

( a )

( b )                                    ( c )

Insulating Spacer 2a              Insulating Spacer 2b
                                  Non-point-symmetric
                                  Structure, Present

TE11 Mode Intensity Distribution

Fig.6

( a )

( b )

Insulating Spacer 2e

( c )

Insulating Spacer 2f
Non-point-symmetric
Structure, Present

( d )

Insulating Spacer 2g
Non-point-symmetric
Structure, Present

TE11 Mode Intensity Distribution

Fig.7

( a )

( b )

Insulating Spacer 2e

( c )

Insulating Spacer 2f
Non-point-symmetric
Structure, Present

( d )

Insulating Spacer 2g
Non-point-symmetric
Structure, Present

TE11 Mode Intensity Distribution

Fig.8

( a )

( b )

Insulating Spacer 2f

( c )

Insulating Spacer 2e,2g
Non-point-symmetric
Structure, Present

TE11 Mode Intensity Distribution

Fig.9

( a )

( b )

Insulating Spacer 2f

( c )

Insulating Spacer 2e,2g
Non-point-symmetric
Structure, Present

TE11 Mode Intensity Distribution

Fig.10

Radius of Metal Tank: a
Radius of Center Conductor: b

4: Electromagnetic Wave Detector
5: Moving Device
6: Displacement Angle Detector
7: Determining Section

Fig.11

Fig.12

4: Electromagnetic Wave Detector
5: Moving Device
6: Displacement Angle Detector

(a)                    (b)                    (c)

TEM Mode            TE11 Mode            TE21 Mode

Fig.13

Fig.14

( a )

( b )                                    ( c )

Cross-section                    Signal Distribution in Tank

Fig.15

Radius of Metal Tank: a
Radius of Center Conductor: b

Input Section — 9

7

TE11 Envelope Detector → TE11 → Pattern Recognition Device → Determining Device

θ

8        14        11

4: Electromagnetic Wave Detector
5: Moving Device
6: Displacement Angle Detector
7: Determining Section

Fig.16

Fig.17

Signal Intensity

I

0°    90°    180°    270°    360°

$\theta_1$        $\theta_2$

Circumferential Position (Angle)

( a )

( b )

Insulating Spacer 2c

( c )

Insulating Spacer 2d

TE11 Mode Intensity Distribution

Fig.18

(a)

(b)

Insulating Spacer 2c

(c)

Insulating Spacer 2d

TE11 Mode Intensity Distribution

Fig.19

(a)

(b)

Fig.20

(a)

(b)                      (c)                      (d)

Insulating               Insulating               Insulating
Spacer 2e                Spacer 2f                Spacer 2g

TE11 Mode Intensity Distribution

Fig.21

(a)

(b)                                    (c)

Insulating Spacer 2f              Insulating Spacer 2e,2g

TE11 Mode Intensity Distribution

Fig.22

( a )

( b )                    ( c )                    ( d )

Insulating                Insulating                Insulating
Spacer 2e                 Spacer 2f                 Spacer 2g

TE11 Mode Intensity Distribution

Fig.23

(a)

(b)

Insulating Spacer 2f

(c)

Insulating Spacer 2e,2g

TE11 Mode Intensity Distribution

Fig.24

**INTERNATIONAL SEARCH REPORT**

| International application No. |
| --- |
| PCT/JP2006/317340 |

**A. CLASSIFICATION OF SUBJECT MATTER**
*G01R31/12(2006.01)i*

According to International Patent Classification (IPC) or to both national classification and IPC

**B. FIELDS SEARCHED**

Minimum documentation searched (classification system followed by classification symbols)
G01R31/12-31/20

Documentation searched other than minimum documentation to the extent that such documents are included in the fields searched
Jitsuyo Shinan Koho          1922-1996   Jitsuyo Shinan Toroku Koho   1996-2006
Kokai Jitsuyo Shinan Koho    1971-2006   Toroku Jitsuyo Shinan Koho   1994-2006

Electronic data base consulted during the international search (name of data base and, where practicable, search terms used)
JSTPlus(JDream2), JST7580(JDream2)

**C. DOCUMENTS CONSIDERED TO BE RELEVANT**

| Category* | Citation of document, with indication, where appropriate, of the relevant passages | Relevant to claim No. |
| --- | --- | --- |
| X<br>Y<br>A | Narumitsu OKABE et al., "GIS-chu Denjiha Mode Henkan o Riyo shita Bubun Hoden Shindanho", Heisei 17 Nen Proceedings of the Annual Conference of Power & Energy Society, 10 August, 2005 (10.08.05), pages 39-11 to 39-12 | 6<br>1-2,4,7-8<br>3,5 |
| Y | JP 2006-170815 A  (Hitachi, Ltd.), 29 June, 2006 (29.06.06), Full text; all drawings & US 2006/0132144 A1 | 1-2,4,7-8 |
| A | Manabu YOSHIMURA et al., "Denjiha Mode o Riyo shita GIS-chu Bubun Hodengen no Dotei Gijutsu", Mitsubishi Denki Giho, 25 July, 2006 (25.07.06), Vol.80, No.7, pages 439 to 442 | 1-8 |

☒ Further documents are listed in the continuation of Box C.     ☐ See patent family annex.

| * | Special categories of cited documents: |
| --- | --- |
| "A" | document defining the general state of the art which is not considered   to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
| --- | --- |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search<br>28 November, 2006 (28.11.06) | Date of mailing of the international search report<br>09 January, 2007 (09.01.07) |
| --- | --- |
| Name and mailing address of the ISA/<br>Japanese Patent Office | Authorized officer |
| Facsimile No. | Telephone No. |

Form PCT/ISA/210 (second sheet) (April 2005)

42

**EP 2 063 276 A1**

| | INTERNATIONAL SEARCH REPORT | International application No. |
|---|---|---|
| | | PCT/JP2006/317340 |

C (Continuation).   DOCUMENTS CONSIDERED TO BE RELEVANT

| Category* | Citation of document, with indication, where appropriate, of the relevant passages | Relevant to claim No. |
|---|---|---|
| A | Manabu YOSHIMURA et al., "GIS-chu Denjiha Mode Henkan eno Tank Keijo no Eikyo", Heisei 17 Nen Proceedings of the Annual Conference of Power & Energy Society, 10 August, 2005 (10.08.05), pages 39-7 to 39-8 | 1-8 |
| A | Hirotaka MUTO et al., "GIS-chu Koji Mode Denjiha Denpan Tokusei (L-jibu, T-jibu) no Simulation Kaiseki", The Institute of Electrical Engineers of Japan Kenkyukai Shiryo, 08 November, 2002 (08.11.02), ED-02-154 to 164, pages 53 to 58 | 1-8 |
| A | Hirotaka MUTO et al., "GIS-chu Koji Mode Denjiha no Denpan Tokusei no Simulation Kaiseki", Heisei 14 Nen Proceedings of the Annual Conference of Power & Energy Society, 07 August, 2002 (07.08.02), pages 125 to 126 | 1-8 |
| E,X E,A | JP 2006-266820 A  (Mitsubishi Electric Corp.), 05 October, 2006 (05.10.06), Full text; all drawings (Family: none) | 6 1-5,7-8 |

Form PCT/ISA/210 (continuation of second sheet) (April 2005)

43

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2005084305 A

**Non-patent literature cited in the description**

- **S. Okabe et al.** Method of diagnosing partial discharge using Electromagnetic wave mode conversion in GIS. *Journal of the Institute of Electrical Engineers of Japan (IEEJ) Transactions on Power and Energy,* 2005